# FASCICULE DE BREVET EUROPEEN

(11) **EP 4 090 927 B1**
(45) Date de publication et mention de la délivrance du brevet: **29.11.2023**
(21) Numéro de dépôt: 21700879.6
(22) Date de dépôt: 14.01.2021
(51) Int. Cl.: G01K 7/02, H01L 23/34, H01L 29/205, H01L 29/778, H01L 21/8252, H01L 27/06, H10N 10/17, H01L 29/20

(54) **COMPOSANT ELECTRONIQUE DE PUISSANCE INTEGRANT UN CAPTEUR THERMOELECTRIQUE**
LEISTUNGSELEKTRONIKBAUTEIL MIT EINEM THERMOELEKTRISCHEN SENSOR
POWER ELECTRONIC COMPONENT INTEGRATING A THERMOELECTRIC SENSOR

(30) Priorité: 16.01.2020 FR 2000404
(43) Date de publication de la demande: 23.11.2022
(73) Titulaire: Commissariat à l'Energie Atomique et aux Energies Alternatives, 75015 Paris (FR)
(72) Inventeur: SAVELLI, Guillaume, 38054 GRENOBLE CEDEX 09 (FR); BRYAN, Charlotte, 38054 GRENOBLE CEDEX 09 (FR); ESCOFFIER, René, 38054 GRENOBLE CEDEX 09 (FR); PLISSONNIER, Marc, 38054 GRENOBLE CEDEX 09 (FR)
(74) Mandataire: Cabinet Nony
(86) Numéro de dépôt international: PCT/EP2021/050731
(87) Numéro de publication internationale: WO 2021/144382

(56) Documents cités:
- JP-A- S63 129 656
- US-B2- 8 872 302

## Description

La présente invention concerne un composant électronique de puissance, comportant un transistor de puissance et un capteur thermoélectrique pour mesurer la température et/ou le flux thermique généré par le transistor de puissance. Elle concerne aussi un procédé de fabrication d'un composant électronique de puissance comportant un transistor et un capteur thermoélectrique.

Au sein d'un composant électronique de puissance, un transistor de puissance, par exemple basé sur un matériau tel que le nitrure de gallium (GaN), l'arséniure de gallium (AsGa), ou le gallium-indium (InGa), s'échauffe sous l'effet de la puissance électrique qu'il génère. Il est donc utile de contrôler l'évolution de la température du transistor pour éviter une surchauffe du composant électronique. A cette fin, le flux thermique et/ou la température du transistor peuvent être mesurés pour adapter la commande électrique du transistor en conséquence.

Actuellement, des résistances variables en fonction de la température, aussi appelées thermistance ou résistances « Tsense » sont mises en oeuvre pour mesurer la température de tels transistors. Elles sont par exemple:
- des thermistances métalliques intégrées à base de platine qui sont découplées de la zone active du composant;
- des thermistances à base de matériaux résistifs autres que le platine, par exemple en NiCr ou TaN, et
- des thermistances externes à base de platine, ou des diodes à base de silicium, qui sont disposés hors du composant électronique.

A titre d'exemple peut être citée la demande de brevet JPS63129656

A qui divulgue un composant électronique de puissance intégrant une diode Schottky permettant de mesurer l'échauffement d'un transistor de puissance du type HEMT.

Ces thermistances nécessitent toutes d'être alimentées électriquement au moyen d'une source de courant. De plus, la mise en oeuvre de ces résistances nécessite une étape supplémentaire lors de la fabrication du circuit intégré.

Il existe donc un besoin pour mesurer simplement la température d'un transistor de puissance au sein d'un composant électronique qui le contient, et de préférence sans complexifier la fabrication du composant électronique.

L'invention répond à ce besoin et propose un composant électronique selon la revendication 1 comportant un support, un capteur thermoélectrique et un transistor de puissance disposés sur le support, le transistor de puissance comportant une couche de base contenant, de préférence consistant en, un matériau de transistor choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges, le composant électronique étant configuré pour que le capteur thermoélectrique génère un courant électrique sous l'effet d'un échauffement du transistor de puissance.
Ainsi, en mesurant le courant et/ou la tension électrique aux bornes du capteur thermoélectrique, l'échauffement et/ou la température du transistor de puissance peuvent être mesurés sans qu'aucune source de courant électrique ne soit nécessaire pour alimenter le capteur thermoélectrique.

De préférence, le transistor de puissance est multicouche.

De préférence, le capteur thermoélectrique est multicouche et comporte une couche de base.

La couche de base du capteur thermoélectrique comporte, pour plus de 99,9 % de sa masse, un matériau de capteur choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges.

De préférence, le matériau de capteur et le matériau de transistor sont identiques. Avantageusement, les couches de base du capteur thermoélectrique et du transistor peuvent ainsi être déposées conjointement, par exemple au moyen d'une unique étape de dépôt. De préférence, le matériau de capteur et le matériau de transistor sont le nitrure de gallium.

La couche de base du capteur thermoélectrique et la couche de base du transistor peuvent être déposées conjointement par un même procédé de dépôt de couche, par exemple par dépôt physique en phase vapeur ou par dépôt chimique en phase vapeur.

La couche de base du capteur thermoélectrique et la couche de base du transistor peuvent être disjointes. Par exemple, elles peuvent être obtenues par un procédé de dépôt d'une couche initiale suivie par une ablation locale, pour séparer la couche initiale en la couche de base du capteur thermoélectrique et en la couche de base du transistor.

Dans la variante où le matériau de capteur et le matériau de transistor sont identiques, la couche de base du capteur thermoélectrique et la couche de base du transistor peuvent être reliées l'une à l'autre et former une couche commune partagée par le capteur thermoélectrique et par le transistor de puissance.

La couche de base du capteur thermoélectrique et la couche de base du transistor peuvent présenter une composition identique.

Une couche présente une face « inférieure » en regard du support et une face « supérieure », opposée à la face inférieure.

De préférence, la couche de base du capteur thermoélectrique et la couche de base du transistor présentent des faces inférieures respectives, disposées à une même hauteur du support. Elles peuvent présenter des épaisseurs identiques.

De préférence, le matériau de transistor et le matériau de capteur sont le nitrure de gallium et la couche de base du capteur thermoélectrique peut être dopée n, l'élément dopant étant notamment le silicium.

Par ailleurs, le transistor de puissance peut comporter un empilement multicouche de transistor. L'empilement multicouche de transistor peut comporter en succession :
- une couche de nitrure d'aluminium, par exemple d'épaisseur égale à 50 nm,
- une couche comportant, pour plus de 99,9 % de sa masse, du nitrure de gallium, par exemple d'épaisseur comprise entre 2 µm et 4 µm, et
- optionnellement, une couche comportant, pour plus de 99,9% de sa masse, du nitrure d'aluminium-gallium, par exemple d'épaisseur comprise entre 10 nm et 40 nm.

De préférence, le capteur thermoélectrique comporte un empilement multicouche de capteur qui présente une même succession de couches que l'empilement multicouche de transistor.

Des couches de même rang au sein respectivement de l'empilement multicouche de transistor et de l'empilement multicouche de capteur présentent de préférence une même composition chimique et peuvent présenter une même épaisseur.

Avantageusement, le capteur thermoélectrique et le transistor de puissance peuvent être fabriqués par une succession d'étapes de dépôt conjointes pour former les couches d'un même rang des empilements respectifs.

Par exemple, l'empilement multicouche de transistor et l'empilement multicouche de capteur peuvent comporter chacun, en succession :
- une couche de nitrure d'aluminium, par exemple d'épaisseur égale à 50 nm,
- une couche comportant, pour plus de 99,9% de sa masse, du nitrure de gallium, par exemple d'épaisseur comprise entre 2 µm et 4 µm, et
- optionnellement, une couche comportant, pour plus de 99,9% de sa masse, du nitrure d'aluminium-gallium, par exemple d'épaisseur comprise entre 10 nm et 40 nm.

Le capteur thermoélectrique et le transistor de puissance sont de préférence distants l'un de l'autre, par exemple d'une distance de séparation comprise entre 1 µm et 500 µm. Le capteur thermoélectrique peut ainsi détecter aisément une augmentation de température du transistor de puissance, par exemple d'au moins 0,1°C.

La couche de base du capteur thermoélectrique peut contenir au moins un élément dopant, comme complément à 100 % de sa masse. La couche de base du capteur thermoélectrique peut ainsi être dopée n ou p, en fonction de l'élément dopant. Le dopage résulte de la présence de l'élément dopant dispersé au sein de la couche de base du capteur thermoélectrique, l'élément dopant modifiant les propriétés électriques du matériau de capteur.

L'élément dopant peut être choisi parmi le silicium, le magnésium, le carbone, le zinc, l'oxygène, le béryllium, le silicium et leurs mélanges.

L'élément dopant peut être intégré au sein de la couche de base du capteur thermoélectrique lors de la croissance par épitaxie du matériau ou par implantation ionique

L'élément dopant peut être dispersé de manière homogène au sein de la couche de base du capteur thermoélectrique. Autrement dit, la concentration en élément dopant peut être sensiblement constante dans la couche de base du capteur thermoélectrique.

En variante, la concentration en élément dopant peut être variable dans la couche de base du capteur thermoélectrique. Elle peut varier le long de l'épaisseur de la couche de de base du capteur thermoélectrique. En particulier, elle peut être plus élevée dans une portion directement sous une face de la couche de base du capteur thermoélectrique que dans le reste de ladite couche. Par « directement sous une face », on entend une portion s'étendant sur au plus 100 nm, voire sur au plus 50 nm, voire sur au plus 25 nm sous une face, de préférence la face supérieure, de la couche de base du capteur thermoélectrique.

La teneur en l'élément dopant dans une portion dopée directement sous une face, de préférence la face supérieure, de la couche de base du capteur thermoélectrique peut être supérieure à 90,0 %, de préférence supérieure à 95,0 %, de préférence supérieur à 99,0 % de préférence supérieure à 99,9 %, de préférence égale à 100 %, en pourcentages atomiques sur la base du nombre d'atomes de l'élément dopant contenus dans la couche de base du capteur thermoélectrique.

En particulier, la couche de base du capteur thermoélectrique dopée peut être constituée d'une portion vierge, exempte de l'élément dopant, et d'une portion dopée, contenant l'élément dopant. La portion vierge peut constituer plus de 90 %, voire plus de 95 % du volume de la couche de base du capteur thermoélectrique. La portion dopée s'étend de préférence directement sous la face supérieure de la couche de base du capteur thermoélectrique.

Par exemple, dans une variante où le matériau de capteur est le nitrure de gallium, la couche de base du capteur thermoélectrique peut présenter une portion dopée s'étendant directement sous sa face supérieure sur une distance d'au moins 10 nm et une portion vierge s'étendant sous la portion dopée sur une distance comprise entre 2 µm et 4 µm, les distances étant mesurées selon l'épaisseur de ladite couche de base.

Par ailleurs, la couche de base du capteur thermoélectrique peut présenter une épaisseur comprise entre 1 µm et 5 µm, notamment entre 2 µm et 4 µm.

Le capteur thermoélectrique comporte au moins un couple thermoélectrique. Un couple thermoélectrique comporte des premier et deuxième organes thermoélectriques, qui présentent chacun des propriétés de conduction électriques différentes et sont reliés électriquement entre eux par une de leurs extrémités.

Le couple thermoélectrique est configuré pour générer une tension électrique sous l'effet d'un changement de température, par effet Seebeck.

De préférence, le transistor de puissance présente au moins une face en regard du capteur thermoélectrique qui s'étend sensiblement perpendiculairement à l'axe selon lequel le couple thermoélectrique s'étend.

Le premier organe thermoélectrique peut être en un matériau semi-conducteur dopé n ou dopé p, et le deuxième organe thermoélectrique peut être en un matériau thermoélectrique semi-conducteur dopé p ou dopé n respectivement ou en un métal thermoélectrique.

Le métal thermoélectrique peut être choisi parmi le titane, l'or, le nickel, le platine, l'aluminium et leurs alliages. Par exemple, le métal thermoélectrique est l'aluminium.

Le premier organe thermoélectrique peut être formé par tout ou partie d'une couche du capteur thermoélectrique qui est dopée n ou dopée p.

Selon une variante, la couche de base du capteur thermoélectrique est dopée n ou dopée p et le premier organe thermoélectrique peut être formé par une portion de la couche de base du capteur thermoélectrique qui contient l'élément dopant.

En particulier, le premier organe thermoélectrique peut être formé au moins en partie, voire intégralement, par la portion dopée de la couche de base du capteur thermoélectrique, telle que décrite ci-dessus, qui de préférence s'étend directement sous la face supérieure de ladite couche de base.

Selon une autre variante, le capteur thermoélectrique peut comporter une couche additionnelle formée d'un matériau semi-conducteur dont au moins une portion est dopée n ou p. La portion dopée peut s'étendre directement sous la face supérieure de la couche additionnelle. De préférence, la couche additionnelle est dopée sur toute son épaisseur.

La couche additionnelle du capteur thermoélectrique est superposée à, et de préférence est au contact de, la face supérieure de la couche de base du capteur thermoélectrique. En particulier, la portion dopée de ladite couche additionnelle peut présenter une distribution homogène en élément dopant. Le premier organe thermoélectrique peut être formé, en tout ou partie par la portion dopée de ladite couche additionnelle. La couche additionnelle du capteur thermoélectrique peut présenter une épaisseur comprise entre 10 nm et 50 nm, par exemple égale à 25 nm.

Par exemple, la couche additionnelle du capteur thermoélectrique est en nitrure d'aluminium gallium et est dopée sur l'intégralité de son épaisseur et la couche de base est en nitrure de gallium et est exempte de dopage.

Par ailleurs, le premier organe thermoélectrique peut présenter une largeur comprise entre 1,0 µm et 20,0 µm, par exemple égale à 4,0 µm et/ou la longueur du premier organe thermoélectrique peut être comprise entre 0,1 mm et 2,0 mm, par exemple est égale à 1,0 mm.

De préférence, le deuxième organe thermoélectrique est superposé à la couche de base du capteur thermoélectrique.

De préférence, il est logé au moins en partie dans une rainure ménagée dans la couche de base du capteur thermoélectrique et/ou, le cas échéant, dans la couche additionnelle du capteur thermoélectrique. De préférence, la rainure s'étend longitudinalement et débouche sur deux bords opposés l'un à l'autre de la couche de base et/ou de la couche additionnelle du capteur thermoélectrique. Elle peut s'étendre selon une direction curviligne ou, de préférence, rectiligne.

La couche de base du capteur thermoélectrique peut comporter une portion dopée et une portion vierge telles que décrites ci-dessus, et la rainure traverse la portion dopée de part en part, le fond de la rainure étant de préférence formé dans la portion vierge. De préférence, la profondeur de la rainure est supérieure à l'épaisseur de la portion dopée de la couche de base du capteur thermoélectrique.

En variante, le capteur thermoélectrique peut comporter une couche additionnelle dopée, au contact de la couche de base non dopée, et la rainure traverse la portion dopée de la couche additionnelle de part en part, le fond de la rainure étant de préférence formé dans ladite couche de base non dopée.

Ainsi, comme cela apparaîtra clairement par la suite, la rainure peut séparer la portion dopée de la couche additionnelle du capteur thermoélectrique, ou la portion dopée de la couche de base du capteur thermoélectrique, en deux parties distinctes. Ces deux parties distinctes définissent ainsi chacune deux premiers organes thermoélectriques isolés électriquement l'un de l'autre, qui peuvent être destinés à former des couples thermoélectriques différents.

Par ailleurs, la rainure peut présenter une section en forme de « U », ou semi-circulaire. La profondeur de la rainure, mesurée entre la face sur laquelle débouche la rainure et le fond de la rainure, peut être compris entre 100 nm et 150 nm. Par exemple, elle est égale à 125 µm. La largeur de la rainure peut être comprise entre 1500 et 3000 nm et/ou la longueur de la rainure peut être comprise entre 0,5 mm et 2,0 mm, par exemple est égale à 1,0 mm.

Le deuxième organe thermoélectrique peut s'étendre sur toute la longueur et, de préférence, sur toute largeur de la rainure.

De préférence, il présente une forme d'une bande, de préférence rectiligne, dont la largeur est comprise entre 1,0 µm et 3,0 µm, par exemple égale à 2,0 µm et une longueur comprise entre 0,5 mm et 2,0 mm, par exemple est égale à 1,0 mm. Par ailleurs, l'épaisseur du deuxième organe thermoélectrique peut être comprise entre 0,5 µm et 1,5 µm, par exemple égale à 1,0 µm.

Par ailleurs, le deuxième organe thermoélectrique peut présenter une épaisseur supérieure à la profondeur de la rainure. Il peut faire saillie de la face de la couche sur laquelle débouche la rainure.

De préférence, observés selon une direction normale au support, le premier organe thermoélectrique et le deuxième organe thermoélectrique présentent chacun une forme d'une bande, curviligne ou de préférence rectiligne. En particulier, le rapport de la longueur du premier organe thermoélectrique, respectivement du deuxième organe thermoélectrique, sur la largeur du premier organe thermoélectrique, respectivement du deuxième organe thermoélectrique, peut être supérieur à 100, de préférence supérieur à 200, de préférence supérieur à 500.

Les premier et deuxième organes thermoélectriques sont de préférence disposés parallèlement l'un à l'autre, un bord long du premier organe thermoélectrique étant en regard d'un bord long du deuxième organe thermoélectrique. Ainsi, le couple thermoélectrique s'étend selon une direction longitudinale parallèle aux directions longitudinales des premier et deuxième organes thermoélectriques.

De préférence, les premier et deuxième organes thermoélectriques sont reliés électriquement entre eux en au moins une zone de connexion électrique et sont isolés électriquement l'un de l'autre en au moins une zone d'isolation électrique.

De préférence, le capteur thermoélectrique comporte un revêtement d'isolation électrique, disposé entre le premier organe thermoélectrique et le deuxième organe thermoélectrique.

Le revêtement d'isolation électrique peut être au contact du premier organe thermoélectrique et du deuxième organe thermoélectrique.

Le revêtement d'isolation électrique est en un matériau électriquement isolant qui peut être choisi dans le groupe formé par Al₂O₃, TiO₂, HfO₂, SiN, SiO₂ et leurs mélanges. De préférence, le matériau électriquement isolant est l'alumine.

La longueur de la zone d'isolation électrique, mesurée selon la direction d'extension du deuxième organe thermoélectrique, peut être comprise entre 0,5 mm et 2,0 mm.
Le revêtement d'isolation électrique peut recouvrir au moins partiellement, voire totalement la ou les faces de la rainure.

La zone d'isolation électrique et la zone de connexion électrique peuvent être disjointes. La zone d'isolation électrique peut être définie par la ou les faces communes aux premier et deuxième organes thermoélectriques et des zones de connexion électrique peuvent être définies par d'autres faces des premier et deuxième organes thermoélectriques. Par exemple, la zone d'isolation électrique est définie par la ou les faces de la rainure, et des zones de connexion électrique respective peuvent être définies respectivement par les faces supérieures des premier et deuxième organes thermoélectriques.

En variante, la zone d'isolation électrique et la zone de connexion électrique peuvent être connexes. Notamment, la zone d'isolation électrique peut comporter une portion des faces communes aux premier et deuxième organes thermoélectriques et au moins une zone de connexion électrique peut comporter une autre portion desdites faces communes.

De préférence, la zone de connexion électrique est disposée à moins de 50 µm, voire à moins de 10 µm d'un bord longitudinal du deuxième organe thermoélectrique.

Le rapport entre la longueur d'extension de la zone de connexion électrique sur la longueur d'extension de la zone d'isolation électrique peut être compris entre 0,0001 et 0,01, lesdites longueurs étant mesurées le long de la direction longitudinale du deuxième organe thermoélectrique.

La zone de connexion électrique peut s'étendre sur une longueur comprise entre 0,5 µm et 2,5 µm.

Par ailleurs, pour assurer la liaison électrique entre le premier organe thermoélectrique et la deuxième organe thermoélectrique, le capteur thermoélectrique peut être conformé de différentes manières.

Les premier et deuxième organes thermoélectriques peuvent être en contact dans la zone de connexion électrique. De préférence, l'aire de contact entre les premier et deuxième organes thermoélectriques est définie par une partie d'une face commune aux premier et deuxième organes thermoélectriques.

En variante, les premier et deuxième organes thermoélectriques peuvent être distants l'un de l'autre et être connectés électriquement par un connecteur électrique.

En particulier, le connecteur électrique peut être un pont électriquement conducteur formé d'une ou plusieurs couches électriquement conductrices, notamment métalliques, superposées au moins partiellement au premier organe thermoélectrique et au deuxième organe thermoélectrique. De préférence, le matériau formant le pont électriquement conducteur est choisi parmi le titane, l'or, l'aluminium, le nickel et leurs alliages, de préférence est l'aluminium.

Le capteur thermoélectrique peut en outre comporter un espaceur électriquement isolant, par exemple en oxyde de silicium, pris en sandwich entre le pont électriquement conducteur et les premier et deuxième organes thermoélectriques.

Le pont électriquement conducteur peut relier des faces, par exemple supérieures, des premier et deuxième organes thermoélectriques, qui sont opposées aux faces recouvertes, de préférence intégralement par le revêtement d'isolation électrique.

De préférence, afin d'augmenter le courant électrique ou la tension électrique générée lors de l'échauffement du transistor de puissance, le capteur thermoélectrique comporte plusieurs couples thermoélectriques.

Les couples thermoélectriques peuvent être connectés électriquement entre eux en parallèle ou, de préférence, en série.

Le premier organe thermoélectrique d'un des couples thermoélectriques peut être relié électriquement, en une zone d'interconnexion électrique, avec le deuxième organe thermoélectrique d'un des autres couples thermoélectriques.

De préférence, la zone d'interconnexion électrique ente deux couples thermoélectriques est disposée à distance de chacune des zones de connexion électriques des deux couples thermoélectriques respectifs. En particulier, la distance entre la zone d'interconnexion électrique et la zone de connexion électrique d'au moins de l'un, de préférence des deux couples thermoélectriques est supérieure à 100 µm, de préférence supérieure à 200 µm, de préférence supérieure à 500 µm. De préférence, le premier organe thermoélectrique d'un des couples thermoélectriques est relié électriquement, au moyen d'un organe d'interconnexion, avec le deuxième organe thermoélectrique d'un des autres couples thermoélectriques. L'organe d'interconnexion est de préférence métallique et relie les premier et deuxième organes thermoélectriques. De préférence, il présente des parties au contact des faces supérieures des premier et deuxième organes thermoélectriques et au moins une partie distante des premier et deuxième organes. Une autre espaceur en matériau électriquement isolant peut être pris en sandwich entre l'autre partie de l'organe d'interconnexion et les premier et deuxième organes thermoélectriques.

Dans la zone d'interconnexion électrique, le premier organe thermoélectrique de l'un des couples thermoélectriques peut être en contact avec le deuxième organe thermoélectrique de l'autre couple thermoélectrique. En variante, le premier organe thermoélectrique de l'un des couples thermoélectriques et le deuxième organe thermoélectrique de l'autre des couples thermoélectriques peuvent être reliés électriquement par un organe d'interconnexion, par exemple tel que décrit ci-dessus.

Par ailleurs, tout ou partie du premier organe thermoélectrique d'un des couples thermoélectriques peut être distant du deuxième organe thermoélectrique d'un des autres couples thermoélectriques. En particulier, ledit premier organe thermoélectrique peut être séparé du deuxième organe thermoélectrique de l'autre couple thermoélectrique par le revêtement d'isolation électrique de l'autre couple thermoélectrique.

De préférence, les couples thermoélectriques sont alignés les uns à côté des autres selon une direction d'alignement qui est oblique, de préférence perpendiculaire, à la direction longitudinale de chaque couple thermoélectrique.

Les couples thermoélectriques peuvent être identiques les unes aux autres. En variante, ils peuvent différer les uns des autres. Par exemple, ils peuvent présenter des dimensions différentes et/ou comporter des moyens de connexion électriques des premier et deuxième organes thermoélectriques différents.

En particulier, le capteur thermoélectrique comporte la répétition régulière, de préférence périodique, selon une direction d'alignement, d'un motif élémentaire formé d'au moins un couple thermoélectrique, en particulier de deux couples thermoélectriques interconnectés électriquement.

Dans un mode de réalisation, les couples thermoélectriques sont reliés électriquement en série. Le premier organe thermoélectrique d'un des couples thermoélectriques peut être distant du premier organe thermoélectrique de chacun des autres couples thermoélectriques et le deuxième organe thermoélectrique d'un des couples thermoélectrique peut être distant du deuxième organe thermoélectrique de chacun des autres couples thermoélectriques. On évite ainsi tout court-circuit au sein du groupe de couples thermoélectriques. De préférence, le premier organe thermoélectrique de l'un des couples thermoélectriques est connecté électriquement au premier organe thermoélectrique d'au moins un des couples thermoélectriques adjacents, par l'intermédiaire du deuxième organe thermoélectrique respectif du couple thermoélectrique adjacent.

Par ailleurs, le transistor de puissance peut être un transistor à effet de champ, dénommé transistor « FET ». De préférence, il est de type HEMT, acronyme anglais de « High Electron Mobility Transistor ».

De préférence, la couche de base du transistor comporte pour plus de 99,9 % de sa masse le matériau de transistor.

Par ailleurs, le support peut être formé de silicium.

Il peut se présenter sous la forme d'une plaque ayant une épaisseur pouvant être supérieure à 0,5 mm, par exemple de 1 mm.

Le support peut être autoporteur, c'est-à-dire qu'il peut se déformer, et notamment fléchir, sans rompre sous l'effet de son propre poids.

Par ailleurs, l'invention concerne un dispositif choisi parmi un convertisseur d'énergie, un boitier de commande d'un moteur, un amplificateur de puissance hyperfréquence, le dispositif comportant un composant électronique selon l'invention.

L'invention concerne encore un procédé de fabrication selon la revendication 11 d'un composant électronique comportant un transistor de puissance et un capteur thermoélectrique ayant des premier et deuxième organes thermoélectriques, le procédé comportant les étapes successives suivantes de :
a) dépôt d'un premier matériau sur un substrat pour former une couche de base du transistor de puissance et une couche de base du capteur thermoélectrique, le premier matériau étant choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges,
b) dopage de type n ou de type p d'au moins une portion de la couche de base du capteur thermoélectrique, ou
   dépôt d'un deuxième matériau au contact de la couche de base du capteur thermoélectrique pour former une couche additionnelle du capteur thermoélectrique, suivi du dopage de type n ou de type p d'au moins une portion, de préférence de l'intégralité, de la couche additionnelle du capteur thermoélectrique,
   le deuxième matériau étant différent du premier matériau et étant choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges,
c) formation d'au moins une rainure traversant de part en part la portion dopée de la couche de base du capteur thermoélectrique ou traversant de part en part la portion dopée de la couche additionnelle du capteur thermoélectrique,
   la portion dopée de la couche de base du capteur thermoélectrique ou de la couche additionnelle du capteur thermoélectrique contigüe à la rainure et qui s'étend le long de la rainure définissant le premier organe thermoélectrique,
d) formation d'au moins un revêtement d'isolation électrique recouvrant en tout ou partie la ou les faces de la rainure,
e) formation d'au moins une couche d'insertion au moins en partie au contact avec le revêtement d'isolation électrique, et optionnellement dopage de type p ou de type n respectivement, de la couche d'insertion, pour former le deuxième organe thermoélectrique.

Le procédé selon l'invention permet de fabriquer sur un même support, et en déposant au moins un même premier matériau, à la fois le transistor de puissance et le capteur thermoélectrique. Il est donc de mise en oeuvre aisée.

De préférence, le procédé de fabrication est mis en oeuvre pour fabriquer le composant électronique selon l'invention.

A l'étape a), le substrat peut comporter, voire peut être constitué par, un support. Le support peut être autoporteur. Par exemple, le support est une plaque de silicium, présentant une épaisseur d'environ 1 mm.

Le substrat peut comporter en outre une couche primaire ou un empilement de couches primaires du capteur thermoélectrique et/ou une couche primaire ou un empilement de couches primaires du transistor de puissance, qui sont disposées sur le substrat.

Le premier matériau peut être déposé au moyen d'une technique choisie parmi le dépôt physique en phase vapeur et le dépôt chimique en phase vapeur.

De préférence, le premier matériau comporte, de préférence pour plus de 99,9% de sa masse, du nitrure de gallium. Il peut consister en du nitrure de gallium.

La couche de base du capteur thermoélectrique et la couche de base du transistor de puissance peuvent être contigües et former un ensemble monolithique. En variante, le procédé peut comporter le dépôt du premier matériau pour former une couche primaire, puis l'ablation d'une partie de la couche primaire pour séparer la couche primaire en deux parties distinctes, définissant respectivement la couche de base du capteur thermoélectrique et la couche de base du transistor.

L'ablation de la pré-couche peut être effectuée par lithographie et gravure.

Par « lithographie et gravure » d'une couche, on entend une technique comportant en succession :
- une étape de dépôt d'un masque par lithographie, notamment par photolithographie, sur la face de la couche, le masque présentant au moins une portion pleine et au moins une portion évidée, et
- une étape de gravure, physique ou chimique, de la partie de la couche recouverte par la portion évidée du masque.

L'épaisseur de la couche de base du capteur thermoélectrique et/ou l'épaisseur de la couche de base du transistor sont de préférence égales, par exemple comprise entre 2 µm et 4 µm.

De préférence, en fin d'étape a), la couche de base du capteur thermoélectrique et la couche de base du transistor présentent des faces inférieures respectives, disposées à une même hauteur du support. Elles peuvent présenter des épaisseurs identiques.

Dans un premier mode de mise en oeuvre, l'étape b) comporte le dopage de type n ou de type p d'au moins une portion de la couche de base du capteur thermoélectrique et l'étape c) comporte la formation d'au moins une rainure traversant de part en part la portion dopée de la couche de base du capteur thermoélectrique,
la portion dopée de la couche de base du capteur thermoélectrique qui s'étend le long de la rainure définissant le premier organe thermoélectrique.

Le dopage peut être mis en oeuvre par implantation ionique de l'élément dopant ou par dopage intrinsèque ou par dopage *in-situ*, et de préférence de telle sorte qu'en fin d'étape b), seule la portion s'étendant directement sous la face supérieure de la couche de base du capteur thermoélectrique est dopée.

L'élément dopant est choisi pour qu'en fin d'étape b) la couche de base du capteur thermoélectrique soit dopée de type n ou soit dopée de type p.

L'élément dopant peut être choisi parmi le magnésium, le carbone, le zinc, l'oxygène, le béryllium, le silicium et leurs mélanges.

De préférence, le procédé comporte les étapes successives suivantes de :
a) dépôt du premier matériau sur le substrat pour former la couche de base du transistor de puissance et la couche de base du capteur thermoélectrique, le premier matériau comportant pour plus de 99,9 % de sa masse, du nitrure de gallium, et
b) dopage de la portion directement sous la face supérieure de la couche de base du capteur thermoélectrique.

Par ailleurs, le procédé peut comporter le dopage de la couche de base du transistor conjointement au dopage de la couche de base du capteur thermoélectrique.

Dans un deuxième mode de mise en oeuvre, l'étape b) comporte le dépôt d'un deuxième matériau au contact de la couche de base du capteur thermoélectrique pour former une couche additionnelle du capteur thermoélectrique, suivi du dopage de type n ou de type p d'au moins une portion de la couche additionnelle du capteur thermoélectrique,
le deuxième matériau étant différent du premier matériau et étant choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges, et l'étape c) comporte la formation d'au moins une rainure traversant de part en part la portion dopée de la couche additionnelle du capteur thermoélectrique,
la portion dopée de la couche additionnelle du capteur thermoélectrique contigüe à la rainure et qui s'étend le long de la rainure définissant le premier organe thermoélectrique.

Le deuxième matériau peut être déposé par une technique de dépôt telle que décrite ci-dessus pour l'étape a).

De préférence, le deuxième matériau comporte, de préférence pour plus de 99,9 % de sa masse, du nitrure d'aluminium gallium. De préférence, le deuxième matériau consiste en du nitrure d'aluminium gallium.

De préférence, la couche additionnelle du capteur thermoélectrique présente une épaisseur comprise entre 10 nm et 40 nm.

Par ailleurs, le dopage de la couche de base du capteur thermoélectrique ou de la couche additionnelle du capteur thermoélectrique peut être effectué par implantation ionique d'un élément dopant, ou par dopage intrinsèque ou par dopage *in-situ.* De préférence, en fin d'étape b), l'intégralité de la couche additionnelle est dopée.

L'élément dopant est choisi pour qu'en fin d'étape b) la couche de base du capteur thermoélectrique ou la couche additionnelle du capteur thermoélectrique soit dopée n ou soit dopée p.

L'élément dopant peut être choisi parmi le magnésium, le carbone, le zinc, l'oxygène, le béryllium, le silicium et leurs mélanges.

De préférence, le procédé comporte les étapes successives suivantes de :
a) dépôt du premier matériau sur le substrat pour former la couche de base du transistor de puissance et la couche de base du capteur thermoélectrique, le premier matériau comportant pour plus de 99,9 % de sa masse, du nitrure de gallium, et
b) dépôt du deuxième matériau sur la couche de base du capteur thermoélectrique pour former la couche additionnelle du capteur thermoélectrique, et dopage de l'intégralité de la couche additionnelle du capteur thermoélectrique, le deuxième matériau comportant pour plus de 99,9 % de sa masse, du nitrure d'aluminium-gallium.

Par ailleurs, le procédé peut comporter, à l'étape b), conjointement à la formation de la couche additionnelle du capteur thermoélectrique, le dépôt du deuxième matériau sur la couche de base du transistor pour former une couche additionnelle du transistor. Par ailleurs, le procédé peut comporter le dopage de la couche additionnelle du transistor, par exemple au moyen du même élément dopant que pour doper la couche additionnelle du capteur thermoélectrique La couche additionnelle du capteur thermoélectrique et la couche additionnelle du transistor peuvent présenter des faces inférieures disposées à une même hauteur par rapport au support.

A l'étape c), la rainure peut être formée par lithographie et gravure de la couche de base du capteur thermoélectrique ou, le cas échéant, de la couche additionnelle, la rainure étant définie par la zone gravée dans ladite couche.

De préférence, la rainure s'étend longitudinalement et débouche sur deux bords opposés l'un à l'autre de la couche de base et/ou de la couche additionnelle du capteur thermoélectrique.

La couche de base du capteur thermoélectrique peut comporter une portion dopée et une portion vierge telle que décrites ci-dessus, et la rainure traverse la portion dopée de part en part. De préférence, la profondeur de la rainure est supérieure ou égale à l'épaisseur de la portion dopée de la couche de base du capteur thermoélectrique. De préférence, le fond de la rainure est de préférence formé dans la portion vierge de la couche de base du capteur thermoélectrique.

En variante, la portion de la couche additionnelle du capteur thermoélectrique peut être au contact de la couche de base non dopée, la rainure traversant ladite portion dopée. De préférence, la profondeur de la rainure est supérieure ou égale à l'épaisseur de la portion dopée de la couche additionnelle du capteur thermoélectrique. De préférence, le fond de la rainure est formé dans ladite couche de base non dopée.

Ainsi, comme cela apparaîtra clairement par la suite, la rainure peut séparer la couche additionnelle du capteur thermoélectrique, ou la portion dopée de la couche de base du capteur thermoélectrique, en deux parties distinctes. Ces deux parties distinctes définissent ainsi chacune deux premiers organes thermoélectriques isolés électriquement l'un de l'autre.

Par ailleurs, la rainure peut présenter une section en forme de « U », ou semi-circulaire. Elle peut s'étendre selon une direction curviligne ou, de préférence, rectiligne.

La profondeur de la rainure, mesurée entre la face sur laquelle débouche la rainure et le fond de la rainure, peut être compris entre 100 nm et 150 nm Par exemple, elle est égale à 125 µm. La largeur de la rainure peut être comprise entre 1500 et 3000 nm et/ou la longueur de la rainure peut être comprise entre 0,5 mm et 2,0 mm, par exemple est égale à 1,0 mm.

De préférence, la rainure s'étend longitudinalement et débouche sur deux bords opposés l'un à l'autre de la couche de base et/ou de la couche additionnelle du capteur thermoélectrique.

De préférence plusieurs rainures sont formées à l'étape c), deux rainures adjacentes étant séparées par un premier organe thermoélectrique adjacent. En particulier, les rainures peuvent être formées de manière à définir un réseau de rainures.

De préférence, observés selon une direction normale au support, les rainures présentent une forme d'une bande rectiligne.

De préférence, les rainures s'étendent selon des directions parallèles. Elles sont de préférences formées à distance les unes des autres selon une direction oblique, de préférence perpendiculaires à leur direction d'extension. Ainsi, deux rainures consécutives sont séparées par un premier organe thermoélectrique. De préférence, deux rainures adjacentes peuvent être séparées par une distance comprise entre 3,0 µm et 5,0 µm, par exemple égale à 4,0 µm.

A l'étape d), le revêtement d'isolation électrique peut être formé en déposant un matériau électriquement isolant dans la rainure. En particulier, le revêtement d'isolation électrique peut être formé en mettant en oeuvre les étapes successives suivantes de :
i) dépôt d'un matériau électriquement isolant sur la couche de base du capteur thermoélectrique, ou le cas échéant sur la couche additionnelle du capteur thermoélectrique, pour former une couche temporaire,
ii) formation d'un masque par lithographie et gravure de la couche temporaire, la portion pleine du masque étant au moins partiellement superposé à la rainure, et iii) décapage du masque de lithographie.

A l'étape i), de préférence, le matériau électriquement isolant est déposé sur une portion non dopée de la couche de base du capteur thermoélectrique, ou le cas échéant sur une partie de la portion non dopée de la couche additionnelle du capteur thermoélectrique.

A l'étape ii), toute méthode de gravure, par exemple chimique, connue de l'homme du métier peut être employée.

Le matériau électriquement isolant peut être choisi parmi Al₂O₃, TiO₂, HfO₂, SiN, SiO₂ et leurs mélanges. Il est de préférence en alumine, dont la formule chimique est Al₂O₃.

Le matériau électriquement isolant peut être déposé par une technique choisie parmi le dépôt de couches atomiques et le dépôt chimique en phase vapeur. Le dépôt de couches atomiques aussi connu sous l'abréviation « ALD », acronyme anglais de « Atomic Layer Deposition ». Le dépôt chimique en phase vapeur est connu sous l'abréviation « CVD », acronyme anglais de « Chemical Vapor Deposition ».

Les portions pleines du masque de lithographie peuvent recouvrir moins de 10 % du premier organe thermoélectrique adjacent à la rainure.

Selon une variante de mise en oeuvre, les portions pleines du masque peuvent recouvrir partiellement la rainure. Ainsi, en fin d'étape d), au moins une face de la rainure est partiellement non recouverte par le revêtement d'isolation électrique. Elle peut ainsi définir une zone de contact électrique entre le premier organe thermoélectrique et le deuxième organe thermoélectrique formé à l'étape e).

Selon une autre variante de mise en oeuvre, les portions pleines du masque peuvent recouvrir intégralement la ou les faces de la rainure.

De préférence, le revêtement d'isolation électrique présente une épaisseur comprise entre 10 nm et 100 nm

De préférence, selon la variante où plusieurs rainures sont formées, le procédé comporte la formation de plusieurs revêtements d'isolation électrique recouvrant chacun au moins partiellement la ou les faces d'une des rainures correspondantes. En particulier, à l'étape ii), le masque peut comporter plusieurs portions pleines, chacune étant au moins partiellement superposée à l'une des rainures correspondantes.

A l'étape e), une couche d'insertion est formée qui est au moins en partie au contact avec le revêtement d'isolation électrique.

La couche d'insertion peut être formée en déposant un troisième matériau dans la rainure.

En particulier, le troisième matériau peut être déposé sur le revêtement d'isolation électrique et, le cas échéant sur la ou les faces de la rainure définies par la portion dopée de la couche de base du capteur thermoélectrique ou sur la portion dopée de la couche additionnelle du capteur thermoélectrique.

En particulier, la couche d'insertion peut être formée en mettant en oeuvre les étapes successives suivantes de :
i') dépôt d'un troisième matériau sur la couche de base du capteur thermoélectrique, ou le cas échéant sur la couche additionnelle du capteur thermoélectrique, ainsi que sur le revêtement d'isolation électrique, pour former une autre couche temporaire,
ii') formation d'un autre masque par lithographie et gravure de l'autre couche temporaire, la portion pleine de l'autre masque étant superposé au moins partiellement, voire totalement au revêtement d'isolation temporaire, et
iii') décapage de l'autre masque de lithographie.

Le troisième matériau peut être un métal thermoélectrique, par exemple l'aluminium.

De préférence, la portion pleine de l'autre masque superposé à la rainure présente, en vue de dessus, une forme d'une bande, de préférence rectiligne.

En variante, le troisième matériau peut être en un matériau semi-conducteur choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges. De préférence, le troisième matériau est le nitrure de gallium ou le nitrure d'aluminium-gallium. Le procédé comporte alors le dopage de la couche d'insertion au moyen d'un élément dopant choisi pour que la couche d'insertion soit dopée n ou dopée p si la couche de base du capteur thermoélectrique et/ou la couche additionnelle du capteur thermoélectrique sont dopées p ou n respectivement.

Ainsi, la couche d'insertion définit un deuxième organe thermoélectrique.

Le deuxième organe thermoélectrique peut s'étendre sur toute la longueur et, de préférence, sur toute largeur de la rainure.

De préférence, il présente une forme d'une bande, de préférence rectiligne, dont la largeur est comprise entre 1,0 et 3,0 µm, par exemple égale à 2,0 µm et une longueur comprise entre 0,5 mm et 2,0 mm, par exemple est égale à 1,0 mm Par ailleurs, l'épaisseur du deuxième organe thermoélectrique peut être comprise entre 0,5 µm et 1,5 µm, par exemple égale à 1,0 µm.

Par ailleurs, le deuxième organe thermoélectrique peut présenter une épaisseur supérieure à la profondeur de la rainure. Il peut faire saillie de la face de la couche sur laquelle débouche la rainure.

Le procédé peut comporter la formation et, optionnellement le dopage, de plusieurs couches d'insertion, chacune contenue dans une des rainures correspondantes.

Ainsi, les couches d'insertion définissent avec des zones adjacentes de la portion dopée de la couche de base du capteur thermoélectrique ou de la portion dopée de la couche additionnelle du capteur électriques plusieurs couples thermoélectriques.

En particulier, à l'étape ii'), l'autre masque peut comporter plusieurs portions pleines, chacune étant au moins partiellement, voire totalement, superposée à l'une des rainures correspondantes.

De préférence, les couches d'insertion sont formées à distance les unes des autres. En particulier, les couches d'insertion peuvent former un réseau, de préférence sensiblement homothétique du réseau de rainures. Notamment, deux couches d'insertion consécutives peuvent être séparées par des portions de la couche de base du capteur thermoélectrique ou, le cas échéant par des portions de la couche additionnelle du capteur thermoélectrique.

Ainsi, en fin d'étape f), le capteur thermoélectrique peut comporter une pluralité de premiers et deuxièmes organes thermoélectriques, qui de préférence, sont disposés en alternance les uns à côtés des autres.

Par ailleurs, selon la variante où le revêtement d'isolation électrique formé en fin d'étape e) recouvre seulement partiellement la ou les faces de la rainure, le procédé peut comprendre le dépôt du troisième matériau dans la portion de la rainure non recouverte par le revêtement d'isolation électrique, au contact de la portion dopée de la couche de base du capteur thermoélectrique, ou le cas échéant au contact de la portion dopée de la couche additionnelle du capteur thermoélectrique. Ainsi, en fin d'étape f), les premier et deuxième organes thermoélectriques sont en contact l'un de l'autre sur une portion de leur longueur, et sont ainsi reliés électriquement. Ils sont en outre isolés électriquement l'un de l'autre par le revêtement d'isolation électrique dans la portion où le deuxième organe thermoélectrique recouvre le revêtement d'isolation électrique. Un couple thermoélectrique du capteur thermoélectrique est ainsi formé.

Par ailleurs, dans la variante où le revêtement d'isolation électrique formé en fin d'étape d) recouvre intégralement la ou les faces de la rainure, le procédé comporte de préférence une étape de formation d'un connecteur électrique reliant électriquement les premier et deuxième organes thermoélectriques. Un couple thermoélectrique du capteur thermoélectrique est ainsi formé.

Plus spécifiquement, le procédé peut comporter la formation d'un espaceur, en un matériau électriquement isolant, par exemple de la silice, superposée aux premier et deuxième organes thermoélectriques suivie par la formation d'un pont électriquement conducteur reliant électriquement les premier et deuxième organes thermoélectriques et se superposant à la l'espaceur.

Dans la variante où plusieurs premiers et deuxièmes organes thermoélectriques sont définis, le procédé peut comporter la formation de plusieurs ponts électriquement conducteurs reliant les premier et deuxièmes organes thermoélectriques correspondants. Une pluralité de couples thermoélectriques sont ainsi formés.

En particulier, le pont électriquement conducteur peut être formé sur les faces supérieures respectives des premier et deuxième organes thermoélectriques.

Par ailleurs, le procédé comporte de préférence la formation d'au moins un organe d'interconnexion pour relier électriquement deux couples thermoélectriques.

Plus spécifiquement, le procédé peut comporter la formation d'un autre espaceur, formé d'un matériau électriquement isolant, par exemple de la silice, superposé au premier organe thermoélectrique de l'un des couples thermoélectrique et au deuxième organe thermoélectrique de l'autre couple thermoélectrique, suivie par la formation de l'organe d'interconnexion qui se superpose à l'autre espaceur, et qui relie électriquement le premier organe thermoélectrique de l'un des couples thermoélectrique au deuxième organe thermoélectrique de l'autre couple thermoélectrique. Une interconnexion électrique entre les couples thermoélectriques est ainsi formée.

En variante, à l'étape d), une portion de la rainure destinée à former le deuxième organe thermoélectrique d'un couple thermoélectrique peut être exempte de revêtement et à l'étape c), on dépose la couche d'insertion au contact de l'organe thermoélectrique du couple thermoélectrique adjacent.

Par ailleurs, le procédé peut comporter, conjointement à la formation de la couche électriquement isolante du capteur thermoélectrique, la formation d'une couche électriquement isolante du transistor faite du même matériau que la couche électriquement isolante du capteur thermoélectrique.

L'invention pourra être mieux comprise à la lecture de la description détaillée qui va suivre et des exemples et au moyen du dessin annexé dans lequel :
[Fig 1] la figure 1 illustre, selon une vue en coupe transversale, une étape du procédé selon un premier exemple de mise en oeuvre,
[Fig 2] la figure 2 illustre, selon une vue en coupe transversale, une autre étape du procédé selon le premier exemple de mise en oeuvre,
[Fig 3] la figure 3 illustre, selon une vue en coupe transversale, une autre étape du procédé selon le premier exemple de mise en oeuvre,
[Fig 4a] la figure 4a illustre, selon une vue en coupe transversale, une autre étape du procédé selon le premier exemple de mise en oeuvre,
[Fig 4b] la figure 4b illustre, selon une vue de dessus, l'étape du procédé illustrée sur la figure 4a,
[Fig 5a] la figure 5a illustre, selon une vue en coupe transversale, une autre étape du procédé selon le premier exemple de mise en oeuvre,
[Fig 5b] la figure 5b illustre, selon une vue de dessus, l'étape du procédé illustrée sur la figure 5a,
[Fig 6] la figure 6 illustre, selon une vue en coupe transversale, une autre étape du procédé selon le premier exemple de mise en oeuvre,
[Fig 7a] la figure 7a illustre, selon une vue en coupe transversale, une autre étape du procédé selon le premier exemple de mise en oeuvre,
[Fig 7b] la figure 7b illustre, selon une vue de dessus, l'étape du procédé illustrée sur la figure 7 a,
[Fig 8] la figure 8 illustre, selon une vue en coupe transversale, une autre étape du procédé selon le premier exemple de mise en oeuvre,
[Fig 9a] la figure 9a illustre, selon une vue en coupe transversale, une autre étape du procédé selon le premier exemple de mise en oeuvre,
[Fig 9b] la figure 9b illustre, selon une vue de dessus, l'étape du procédé illustrée sur la figure 9a,
[Fig 10] la figure 10 illustre, selon une vue en coupe transversale, une autre étape du procédé selon le premier exemple de mise en oeuvre,
[Fig 11a] la figure 11a illustre, selon une vue en coupe transversale, une autre étape du procédé selon le premier exemple de mise en oeuvre,
[Fig 11b] la figure 11b illustre, selon une vue de dessus, l'étape du procédé illustrée sur la figure 11a,
[Fig 12a] la figure 12a illustre, selon une vue en coupe transversale selon le plan de coupe (II), une autre étape du procédé selon le premier exemple de mise en oeuvre,
[Fig 12b] la figure 12b illustre, selon une vue de dessus, l'étape du procédé illustrée sur la figure 12a,
[Fig 13a] la figure 13a illustre, selon une vue en coupe transversale, une autre étape du procédé selon le premier exemple de mise en oeuvre,
[Fig 13b] la figure 13b illustre, selon une vue de dessus, l'étape du procédé illustrée sur la figure 13a,
[Fig 14] la figure 14 illustre, selon une vue en coupe transversale, un composant électronique selon l'invention fabriqué selon le premier exemple de mise en oeuvre,
[Fig 15] la figure 15 illustre, selon une vue de dessus, une étape du procédé selon un deuxième exemple de mise en oeuvre,
[Fig 16] la figure 16 illustre, selon une vue en coupe transversale selon le plan de coupe (AA), l'étape du procédé illustrée sur la figure 15,
[Fig 17] la figure 17 illustre, selon une vue en coupe transversale selon le plan de coupe (CC), l'étape du procédé illustrée sur la figure 15,
[Fig 18] la figure 18 illustre, selon une vue en coupe transversale, une étape du procédé selon un troisième exemple de mise en oeuvre,
[Fig 19] la figure 19 illustre, selon une vue en coupe transversale, un composant électronique selon l'invention fabriqué selon le troisième exemple de mise en oeuvre, et
[Fig 20] la figure 20 est une vue de dessus schématique d'un autre exemple de composant électronique selon l'invention.

Par souci de clarté du dessin, les proportions des différents éléments constitutif des composants électroniques illustrés ne sont pas représentés à l'échelle.

### Exemple 1

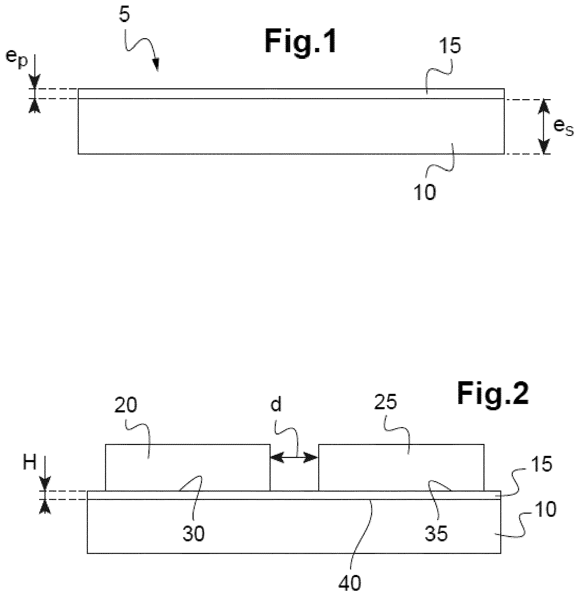

On a représenté sur les figures 1 à 14 un premier exemple de mise en oeuvre du procédé selon l'invention, pour fabriquer un exemple de composant électronique selon l'invention.

A l'étape a), comme illustré sur la figure 1, on dispose d'un substrat 5 qui comporte un support 10 en silicium et une couche primaire 15 en nitrure d'aluminium, qui recouvre le substrat. Par exemple, l'épaisseur du support eₛ est égale à 1,0 mm et l'épaisseur de la couche primaire eₚ de nitrure d'aluminium est égale à 50 nm.

A l'étape b), du nitrure de gallium est déposé, par exemple par dépôt physique en phase vapeur ou par dépôt chimique en phase vapeur, au contact de la couche primaire de nitrure d'aluminium. Une couche initiale est ainsi formée. La couche initiale peut ensuite être séparée en deux parties distinctes, par exemple par lithographie et gravure, pour former une couche de base 20 du transistor de puissance et une couche de base 25 du capteur thermoélectrique, comme illustré sur la figure 2. La couche de base du transistor de puissance et la couche de base du capteur thermoélectrique sont séparées d'une distance de séparation d, choisie de sorte que le capteur thermoélectrique génère une tension électrique sous l'effet de l'échauffement du transistor. La distance de séparation d est par exemple comprise entre 1 µm et 1000 µm Par ailleurs, les faces inférieures respectives 30, 35 des couches de base 20 et 25 peuvent être disposées à une même hauteur H de la face supérieure 40 du support.

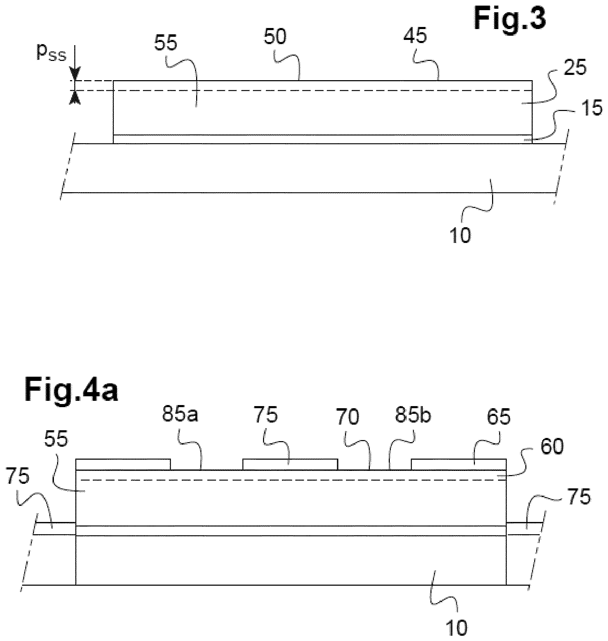

Selon une variante , comme cela est illustré sur la figure 3, la couche de base 25 du capteur multicouche est dopée à l'étape b), par exemple par implantation ionique. Un élément dopant, par exemple du silicium est introduit par la face supérieure de la couche de base 25, et diffuse dans une portion dopée 45 directement sous la face supérieure 50 de la couche de base 25. Ainsi, la couche est dopée n. Par exemple, la portion dopée 45 s'étend sur une épaisseur pₛₛ sous la face supérieure égale à 25 nm. Sur la figure 3, la ligne en pointillés représente la frontière entre la portion vierge 55 de la couche de base 25 dans laquelle la couche de base est sensiblement exempte de l'élément dopant et la portion dopée 45, dans laquelle plus de 99 % de l'élément dopant est concentré.

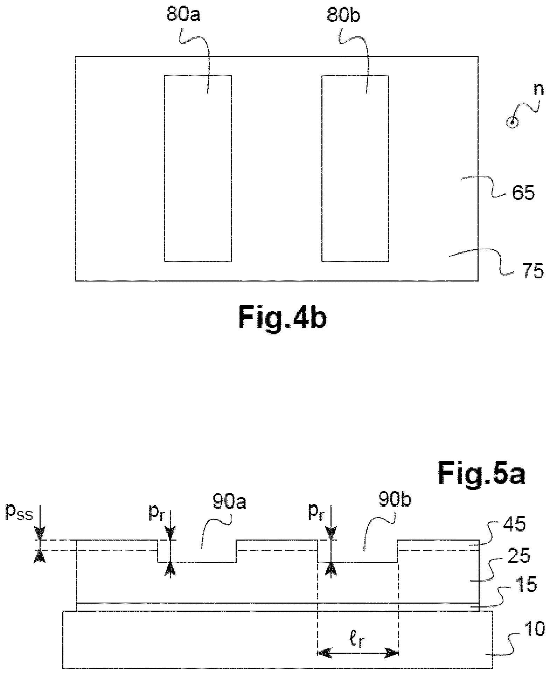

A l'étape c), des rainures sont formées sur la face supérieure de la couche de base du capteur thermoélectrique. Comme cela est illustré sur les figures 4a et 4b, un masque 65 est formé par photolithographie sur la face supérieure 70 de la couche de base 25 du capteur thermoélectrique. Il comporte au moins une portion pleine 75, constituée par exemple d'une résine thermosensible, et des évidements 80a-b se superposant à des portions 85a-b de la face supérieure de la couche de base où les rainures sont destinées à être formées.

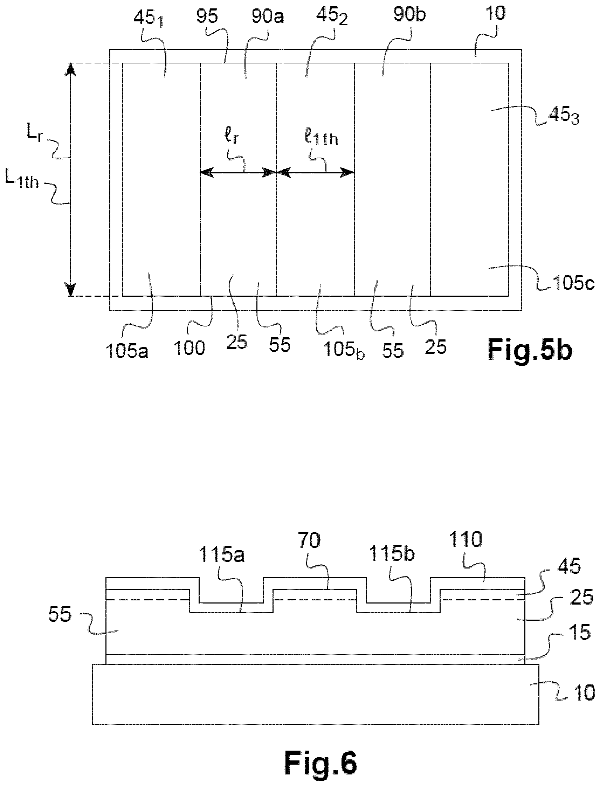

La couche de base du capteur thermoélectrique est ensuite gravée dans les portions 85a-b non recouvertes par les portions pleines du masque. Puis le masque est retiré par décapage. Comme illustré sur les figures 5a et 5b, des rainures 90a-b sont ainsi formées, dont les profondeurs respectives pᵣ sont supérieures à l'épaisseur pₛₛ de la portion dopée 45. Les rainures présentent chacune une forme d'une bande, vue selon une direction normale n au support, qui s'étend sur toute la longueur de la couche de base du capteur thermoélectrique entre deux de ses bords 95, 100 opposés l'un à l'autre.

Ainsi, des premiers organes thermoélectriques 105a-c de couples thermoélectriques en formation sont créés, qui comportent respectivement des parties 45a, 45b et 45c de la portion dopée 45.

Ils présentent chacun, vus selon une direction normale au support, une forme d'une bande, et s'étendent parallèlement aux rainures adjacentes.

Les premiers organes thermoélectriques 105a-c sont ainsi distants et isolés électriquement les uns des autres, les rainures présentant des profondeurs pᵣ supérieures à l'épaisseur pₛₛ de la portion dopée 45, et s'étendant de part en part entre les bords 95 et 100.

Dans l'exemple illustré, chaque rainure présente une longueur Lᵣ de 1,0 mm, une largeur lᵣ de 2,06 µm et une profondeur pᵣ de 125 nm environ et chacun des premiers organes thermoélectriques présente une longueur L₁ₜₕ de 1,0 mm, identique à la longueur d'une rainure, une largeur l₁ₜₕ de 4,0 µm et une épaisseur, correspondant à l'épaisseur de la portion dopée 45, égale à 25 nm.

A l'étape d), on forme un revêtement d'isolation électrique. Un matériau électriquement isolant peut être déposé, comme illustré sur la figure 6, sur la face supérieure 70 de la couche de base 25 du capteur thermoélectrique, et sur les faces de fond 115a-b respectives des rainures. Une couche temporaire 110 est ainsi formée. Le matériau électriquement isolant est par exemple de l'alumine et peut être déposé par CVD, ALD ou PECVD.

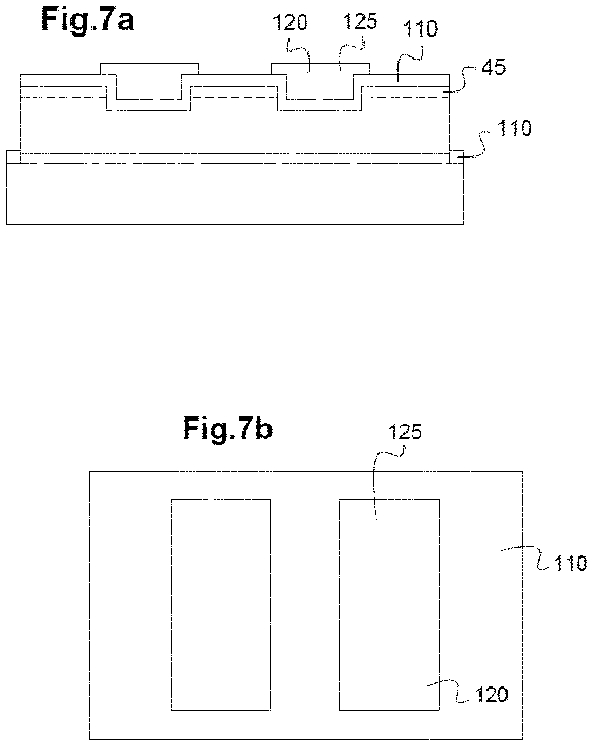

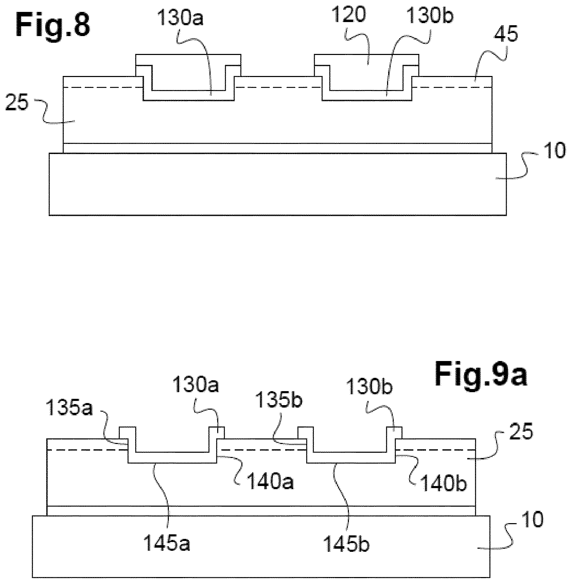

Un masque 120 est ensuite généré par photolithographie, les portions pleines 125 du masque étant superposées intégralement à la rainure, comme illustré sur les figures 7a et 7b. La couche temporaire est ensuite gravée dans sa ou ses parties non recouvertes par les portions pleines du masque, comme illustré sur la figure 8. Après décapage des portions pleines du masque, des revêtements d'isolation électrique 130a-b sont formés, chacun recouvrant entièrement les faces latérales 135a-b,140a-b et la face de fond 145a-b de chacune des rainures. Ainsi, chaque revêtement d'isolation électrique s'étend selon toute la largeur et sur toute la longueur de la rainure qu'il recouvre.

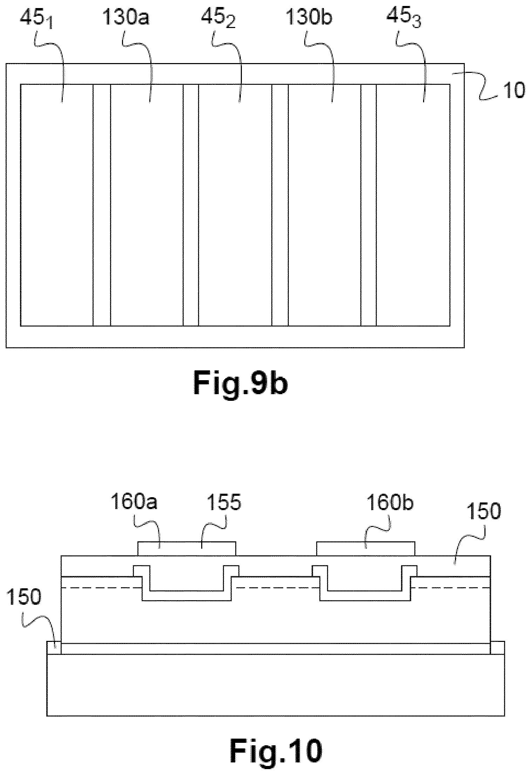

A l'étape c), dans l'exemple illustré, on dépose un troisième matériau, par exemple un métal thermoélectrique, en particulier de l'aluminium, sur la face supérieure de la couche de base du capteur thermoélectrique et sur le revêtement d'isolation électrique, de manière à former une autre couche temporaire 150. Un autre masque 155 est ensuite formé par photolithographie, dont les portions pleines 160a-b recouvrent intégralement la rainure, comme illustré sur la figure 10.

Après gravure de l'autre couche temporaire et décapage de l'autre masque, des couches d'insertion 170a-b sont formées qui remplissent chacune entièrement une rainure correspondante. Chaque couche d'insertion fait saillie de la face supérieure de la couche de base du capteur thermoélectrique. Par ailleurs, les couches d'insertion étant formées en un matériau thermoélectrique, elles définissent chacune des deuxièmes organes 175a-b thermoélectriques destinés à former, avec des premiers organes thermoélectriques correspondants, des couples thermoélectriques.

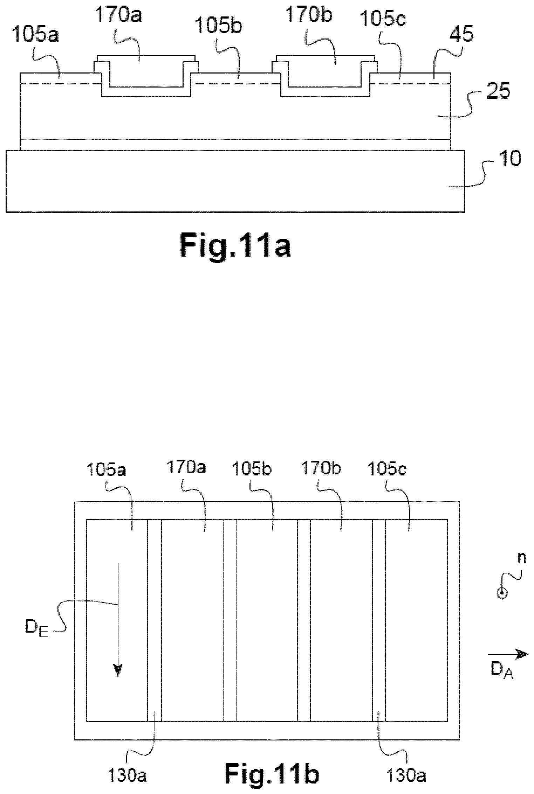

Chaque deuxième organe thermoélectrique est ainsi contigu à un premier organe thermoélectrique. Le revêtement d'isolation électrique forme une barrière entre un premier organe thermoélectrique et un deuxième organe thermoélectrique adjacent, qui sont ainsi isolés électriquement l'un de l'autre, comme illustré sur les figures 11a et 11b.

Par ailleurs, observés selon la direction n normale au support, les premier et deuxième organes thermoélectriques s'étendent chacun selon des directions d'extension D_{E} parallèles les unes aux autres, et sont alignés côte à côte en alternance selon une direction d'alignement D_{A} perpendiculaire à la direction d'extension D_{E}. Deux premier et deuxième organes thermoélectriques adjacents forment ainsi un motif qui est répété régulièrement selon la direction d'alignement D_{A}.

Dans une variante non illustrée, le troisième matériau peut être un semi-conducteur et le procédé peut comporter le dopage de la couche d'insertion pour lui conférer des propriétés thermoélectriques. Dans l'exemple illustré, la couche de base 25 est en nitrure de gallium dopé n, le troisième matériau peut être du nitrure de gallium ou du nitrure d'aluminium-gallium et la couche d'insertion peut être dopée p en implantant du béryllium, du magnésium, du zinc ou du carbone.

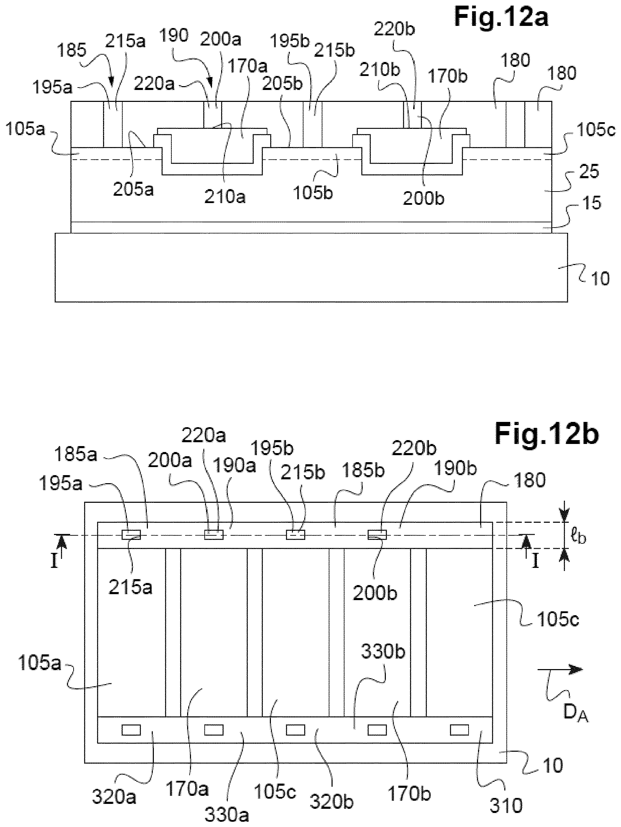

Comme décrit ci-dessus, dans l'exemple illustré, en fin d'étape c), les premiers organes thermoélectriques sont isolés électriquement des deuxièmes organes thermoélectriques par l'intermédiaire du revêtement d'isolation électrique. Afin de former des couples thermoélectriques aptes à générer un effet Seebeck, le procédé mis en oeuvre à l'exemple 1 comporte le dépôt d'une première couche en silice 180 qui recouvre à la fois les parties 185a-b, 190a-b d'extrémité longitudinale des premiers organes thermoélectriques et des deuxièmes organes thermoélectriques respectivement. Comme illustré sur les figures 12a et 12b, la première couche de silice s'étend de part en part sur la couche de base du capteur thermoélectrique et sur les couches d'insertion, selon la direction d'alignement D_{A}. Vue selon la direction normale au support, la couche de silice présente ainsi une forme d'une bande rectiligne dont la largeur l_{b} est par exemple égale à 5,5 µm. En outre, la première couche de silice comporte des première 195a-b et deuxième 200a-b fenêtres la traversant dans son épaisseur et qui débouchent sur la face supérieure 205a-b du premier organe thermoélectrique et sur la face supérieure 210a-b du deuxième organe thermoélectrique respectivement. En outre, le procédé comporte la formation de premier 215a-b et deuxième 220a-b plots électriquement conducteurs, par exemple métalliques, et en particulier en aluminium, qui sont logés dans les fenêtres. Les fenêtres ainsi que les plots électriquement conducteurs peuvent être formés successivement, par une technique de lithographie et gravure telle que décrite dans la présente description par ailleurs.

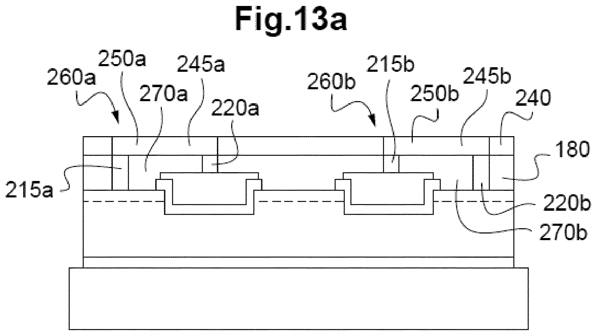

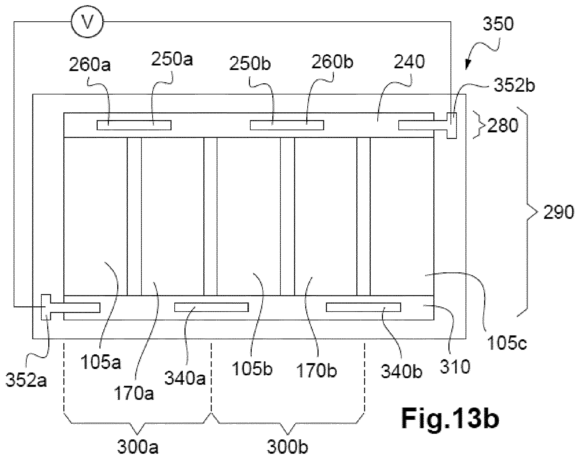

Enfin, le procédé mis en oeuvre à l'exemple 1 comporte, comme illustré sur les figures 13a et 13b la formation d'une deuxième couche de silice 240 qui est superposée intégralement à la première couche de silice 180 et *vice versa.* La deuxième couche comporte une autre fenêtre 245a-b qui la traverse de part en part dans son épaisseur et qui débouche sur les premier 220a-b et deuxième 225a-b plots électriquement conducteurs. L'autre fenêtre est par ailleurs superposée à la première couche de silice et à un premier organe thermoélectrique et à un deuxième organe thermoélectrique adjacents. Une bande 250a-b électriquement conductrice, par exemple en aluminium, est logée dans la fenêtre et est au contact des premier et deuxième plots électriquement conducteurs. Ainsi, les plots et la bande électriquement conducteurs définissent un pont 260a-b électriquement conducteur qui relie des premier 105a-b et deuxième 170a-b organes thermoélectriques adjacents. Par ailleurs, la portion de la première couche de silice prise en sandwich entre le pont électriquement conducteur et les organes thermoélectriques, est un espaceur électriquement isolant 270a-b.

Les premier et deuxième organes thermoélectriques sont ainsi connectés électriquement dans une zone de connexion électrique 280 s'étendant sur la portion d'extrémité longitudinale sur une longueur inférieure à la largeur l_{b} de la bande de silice, et sont isolés électriquement l'un de l'autre sur une zone d'isolation électrique 290 qui s'étend sur la longueur de la rainure. Des couples thermoélectriques 300a-b sont ainsi crées, qui comporte chacun des premier 105a-b et deuxième 170a-b organes thermoélectriques reliés par le pont électriquement conducteur 260a-b respectivement, qui sous l'effet de l'échauffement du transistor est apte à générer un courant électrique par effet Seebeck.

Pour augmenter la tension générée par le capteur, les couples thermoélectriques peuvent être interconnectés en série les uns aux autres. Conjointement à la formation de la première couche de silice 180, le procédé comporte la formation d'une autre couche de silice 310 qui recouvre les parties 320a-b, 330a-b d'extrémité longitudinale des premiers organes thermoélectriques et des deuxièmes organes thermoélectriques respectivement, à l'opposé de la première couche de silice 180. Des organes d'interconnexion 340a-b reliant le deuxième organe thermoélectrique, par exemple 170a d'un couple thermoélectrique, par exemple 300a, au premier organe thermoélectrique, par exemple 105b, d'un couple thermoélectrique adjacent, par exemple 105b, sont formés, selon un procédé identique à celui décrit ci-dessus pour générer les ponts électriquement conducteurs.

Un capteur thermoélectrique 350, formé de couples thermoélectriques reliés électriquement en série est ainsi obtenu au moyen du procédé mis en oeuvre à l'exemple 1.

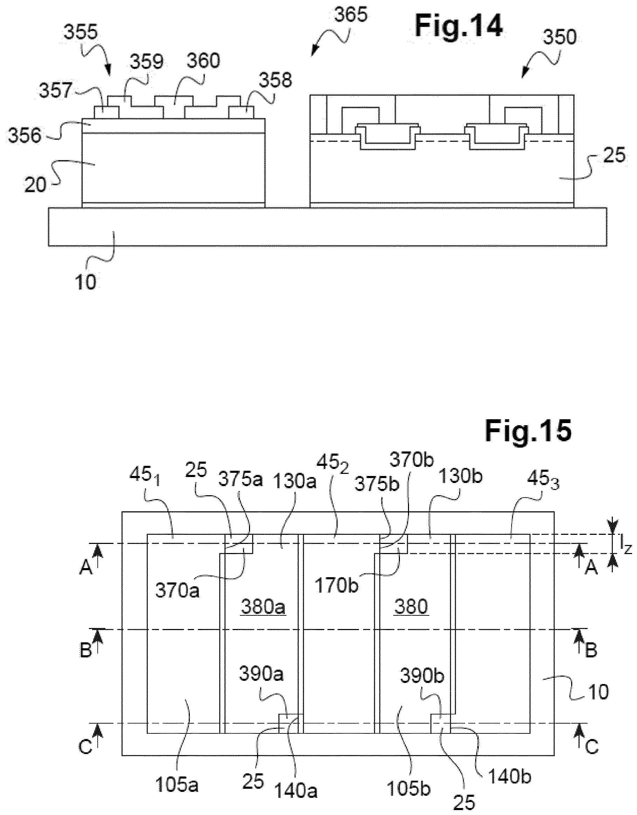

Il peut être relié à un voltmètre ou à un ampèremètre, par l'intermédiaire de pâtes de connexion 352a-b déposées sur le support et auxquelles il est relié, pour mesurer la tension électrique ou le courant électrique généré respectivement par le transistor de puissance 355 disposé sur le support à proximité, comme illustré sur la figure 14.

Par ailleurs, le procédé peut comporter la formation d'une ou plusieurs couches empilées sur la couche de base du transistor, pour former le transistor de puissance 355.

Par exemple, le procédé comporte la formation d'une couche additionnelle 356 du transistor, par exemple formée de nitrure d'aluminium-gallium, au contact de la couche de base 20 du transistor en nitrure de gallium. La couche additionnelle du transistor est par exemple dopée n dans l'exemple illustré. Elle peut être formée par une étape consécutive au dépôt des couches de base du transistor et du capteur thermoélectrique. Le procédé comporte en outre la formation d'une couche de drain 357 et d'une couche source 358 qui sont métalliques et qui par exemple sont en partie formées au cours de l'opération de dépôt du troisième matériau de la couche d'insertion du capteur thermoélectrique. Une couche d'isolation 359 du transistor ainsi qu'une couche de grille 360 peuvent finalement être formées sur la couche additionnelle. Un composant électronique 365 comportant un transistor de puissance 355 de type HEMT est ainsi obtenu qui est disposé sur le support auprès du capteur thermoélectrique 350.

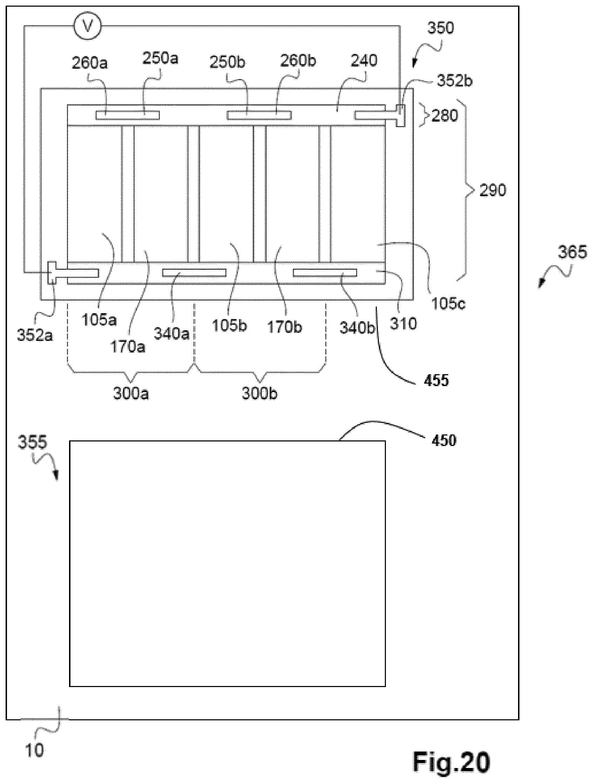

Le composant électronique 365 illustré sur la figure 20 diffère de celui illustré sur la figure 14 par la disposition du transistor 355 relativement au capteur thermoélectrique 350. Une face 450 du transistor est disposée en regard d'une face 455 du capteur thermoélectrique, qui est sensiblement perpendiculaire aux directions d'extension des premier 105a-b et deuxième 170a-b organes thermoélectrique. Une telle disposition relative du transistor par rapport au capteur thermoélectrique optimise la génération d'un courant électrique par le capteur thermoélectrique lors de l'échauffement du transistor. La précision de la mesure de l'élévation du température du transistor peut ainsi être améliorée.

### Exemple 2

Le capteur thermoélectrique du composant électronique de l'exemple 2, selon l'invention, diffère de celui illustré dans l'exemple 1 en ce que les premier et deuxième organes thermoélectriques d'un couple thermoélectriques sont en contact direct l'un avec l'autre dans une zone de connexion électrique 370.

Le capteur thermoélectrique peut être fabriqué en mettant en oeuvre les étapes a) à c) décrites ci-dessus pour former une rainure dans la couche de base dopée du capteur thermoélectrique.

Comme illustré sur la figure 15, le procédé de fabrication diffère de celui mis en oeuvre dans l'exemple 1, en ce que l'on forme un revêtement d'isolation électrique 130a-b qui recouvre partiellement seulement les faces de la rainure. Pour former un tel revêtement, un masque est déposé sur la couche temporaire 110, qui est non superposé à une portion de la rainure dans une portion d'extrémité longitudinale 370a-b de la rainure. En particulier, dans ladite portion d'extrémité longitudinale, le revêtement d'isolation électrique 130a recouvre la partie de la rainure contiguë à une portion dopée 45₂ de la couche de base du capteur thermoélectrique destinée à former un premier organe thermoélectrique 105b d'un autre couple thermoélectrique adjacent. On évite ainsi la formation d'un court-circuit au sein du capteur thermoélectrique.

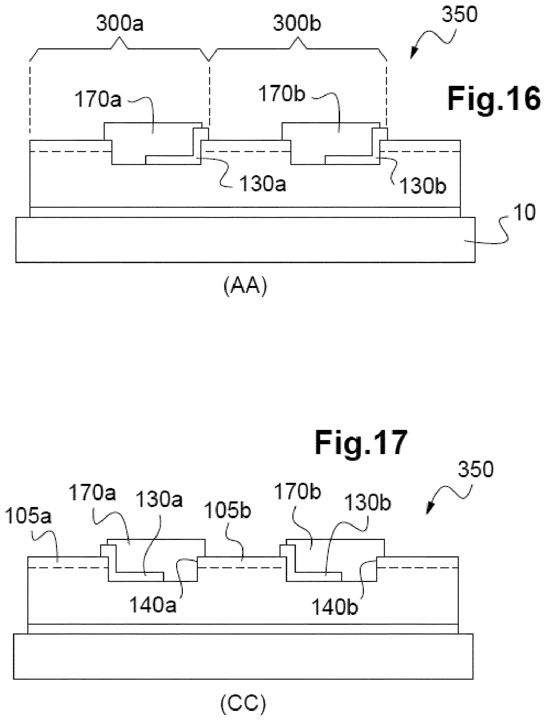

Le procédé comporte ensuite la formation d'une couche d'insertion comme décrit dans l'exemple 1, qui remplit l'intégralité du volume de la rainure. Comme illustré sur la figure 16, le deuxième organe thermoélectrique 170a-b ainsi formé est, dans la portion d'extrémité de la rainure, en contact direct avec un premier organe thermoélectrique adjacent dans une zone de connexion électrique 375a-b et isolé électriquement de l'autre premier organe thermoélectrique adjacent. La zone de contact électrique peut notamment s'étendre, sur une distance L_{z} mesurée selon la longueur de la rainure, inférieure à 10 µm. Par ailleurs, dans la zone d'isolation électrique 380a-b, où le revêtement d'isolation électrique recouvre entièrement les faces de la rainure, les premier et deuxième organes thermoélectriques sont distants les uns des autres et isolés électriquement, comme illustré déjà sur la figure 11a.

Le procédé selon le deuxième est ainsi particulièrement simple de mise en oeuvre. Le capteur thermoélectrique peut être fabriqué avec un nombre limité de couches à déposer.

Par ailleurs, afin d'interconnecter deux couples thermoélectriques adjacents, le revêtement d'isolation électrique est non superposé, dans la portion d'extrémité 390a-b opposée de la rainure, à la face de la rainure 140a-b contiguë à la portion dopée de la couche de base du capteur thermoélectrique destinée à former un premier organe thermoélectrique d'un autre couple thermoélectrique. Ainsi, dans la zone d'interconnexion électrique comme illustré sur la figure 17, le deuxième organe thermoélectrique 170a d'un couple thermoélectrique 300a est en contact direct avec le premier organe thermoélectrique 105b du couple thermoélectrique 300b adjacent. Les couples thermoélectriques adjacents sont ainsi reliés en série.

### Exemple 3

Le procédé de fabrication selon l'invention mis en oeuvre à l'exemple 3 diffère de celui mis en oeuvre à l'exemple 1 en ce qu'à l'étape b), il comporte le dépôt d'un deuxième matériau contact de la couche de base du capteur thermoélectrique pour former une couche additionnelle 385 du capteur thermoélectrique.

De préférence, le deuxième matériau est déposé conjointement, à l'étape b), sur la couche de base du transistor pour former une couche additionnelle du transistor 356. Ainsi, le capteur thermoélectrique 350 et le transistor de puissance peuvent comporter respectivement un empilement multicouche de capteur 390 et un empilement multicouche de transistor 400 disposés sur le support 10 et formés d'une succession de couches comportant les mêmes matériaux.

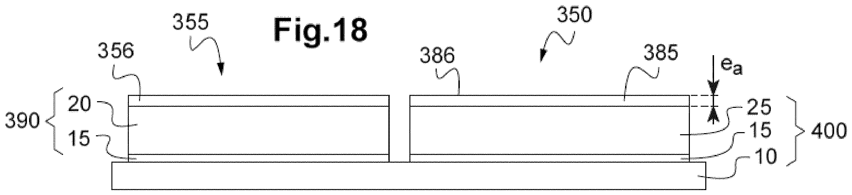

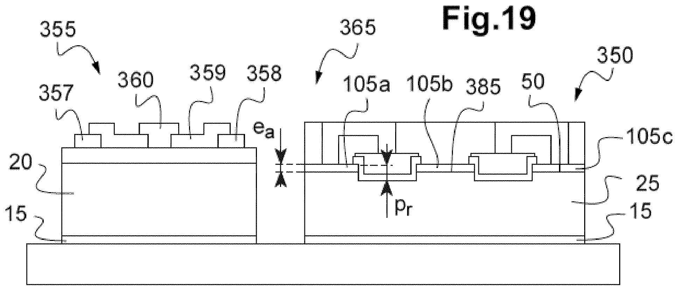

Dans l'exemple illustré sur les figures 18 et 19, l'empilement multicouche de capteur et l'empilement multicouche de transistor comportent une même succession de couches consistant en :
- une couche primaire 15 en nitrure d'aluminium,
- une couche de base 20, 25 en nitrure de gallium non dopé, et
- une couche additionnelle 356, 385 en nitrure d'aluminium gallium.

Par ailleurs, le procédé comporte le dopage de la couche additionnelle de capteur, et optionnellement de la couche additionnelle du transistor. Dans l'exemple illustré, en fin d'étape b), la couche additionnelle du capteur thermoélectrique est en nitrure d'aluminium gallium dopée n sur toute son épaisseur. En variante, elle peut être dopée seulement sur une portion, qui par exemple s'étend directement sous la face supérieure 386 de la couche additionnelle du capteur thermoélectrique.

A l'étape c), des rainures sont formées selon une technique de lithographie et gravure telle que décrite à l'exemple 1, le procédé étant mené de telle sorte que la profondeur de la rainure pᵣ est supérieure ou égale à l'épaisseur eₐ de la couche additionnelle dopée, le fond de chaque rainure étant défini par une face de la couche de base du capteur thermoélectrique en nitrure de gallium non dopé. Ainsi, des premiers organes thermoélectriques 105a-c, formés de nitrure d'aluminium gallium dopé n sont formés, qui sont électriquement isolés les uns des autres par la couche de base du capteur thermoélectrique.

Les autres étapes pour former les deuxièmes organes thermoélectriques, puis pour relier entre les premier et deuxième organes thermoélectriques pour créer des couples thermoélectriques, et enfin pour relier les couples thermoélectriques en série sont identiques à celles décrites dans l'exemple 1.

En variante, le transistor du composant électronique de la figure 19 peut être disposé par rapport au capteur thermoélectrique comme illustré sur la figure 20.

### Exemple 4

Le procédé de fabrication de l'exemple 4, non illustré, diffère de celui décrit dans l'exemple 3, en ce qu'il comporte une étape de formation du revêtement d'isolation électrique telle que décrite à l'exemple 2. Ainsi, le deuxième organe thermoélectrique est au contact du premier organe thermoélectrique en nitrure d'aluminium de gallium dopé dans la zone de connexion électrique.

Bien évidemment, l'invention n'est pas limitée aux exemples et modes de réalisation du composant électronique et modes de mise en oeuvre du procédé décrits dans la demande. Par exemple, le capteur thermoélectrique peut être formé sur un autre support, puis transféré sur le support sur lequel repose le transistor de puissance.

## Revendications

1. Composant électronique (365) comportant un support (10), un capteur thermoélectrique (350) et un transistor de puissance (355) disposés sur le support, le transistor de puissance comportant une couche de base (20) contenant un matériau de transistor choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges,
le composant électronique étant configuré pour que le capteur thermoélectrique génère un courant électrique sous l'effet d'un échauffement du transistor de puissance.

2. Composant électronique selon la revendication 1, le capteur thermoélectrique étant multicouche et comportant une couche de base (25) comportant, pour plus de 99,9 % de sa masse, un matériau de capteur choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges, le matériau de capteur et le matériau de transistor étant de préférence identiques, de préférence étant le nitrure de gallium.

3. Composant électronique selon la revendication 2, la couche de base du capteur thermoélectrique étant dopée n ou p au moyen d'un élément dopant, la couche de base du capteur thermoélectrique étant en particulier constituée d'une portion vierge (55) exempte de l'élément dopant, et d'une portion dopée (45) contenant l'élément dopant, la portion dopée s'étendant de préférence directement sous la face supérieure (50) de la couche de base (25) du capteur thermoélectrique.

4. Composant électronique selon l'une quelconque des revendications précédentes, le capteur thermoélectrique comportant au moins un couple thermoélectrique (300a-b) incluant des premier (105a-b) et deuxième (170a-b) organes thermoélectriques, le premier organe thermoélectrique étant en un matériau semi-conducteur dopé n ou dopé p, et le deuxième organe thermoélectrique étant en un matériau thermoélectrique semi-conducteur dopé p ou dopé n respectivement ou en un métal thermoélectrique.

5. Composant électronique selon la revendication précédente, le premier organe thermoélectrique (170a-b) étant formé par tout ou partie d'une couche du capteur thermoélectrique qui est dopée n ou dopée p, de préférence au moins en partie par la portion dopée (45a-c) de la couche de base du capteur thermoélectrique.

6. Composant électronique selon l'une quelconque des revendications 2 à 4, le capteur thermoélectrique comportant une couche additionnelle (385) formée d'un matériau semi-conducteur dont au moins une portion est dopée n ou p, la couche additionnelle (385) étant superposée à, et de préférence est au contact de, la face supérieure (50) de la couche de base (25) du capteur thermoélectrique,
le premier organe thermoélectrique (105a-b) étant de préférence formé en tout ou partie par la portion dopée de ladite couche additionnelle (385).

7. Composant électronique selon l'une quelconque des revendications 4 à 6, le deuxième organe thermoélectrique étant logé au moins en partie dans une rainure (90a-b) ménagée dans la couche de base du capteur thermoélectrique et/ou, le cas échéant, dans la couche additionnelle du capteur thermoélectrique.

8. Composant électronique selon l'une quelconque des revendications 4 à 7, le capteur thermoélectrique comportant un revêtement d'isolation électrique (130a-b) en un matériau électriquement isolant, disposé entre le premier organe thermoélectrique et le deuxième organe thermoélectrique.

9. Composant électronique selon l'une quelconque des revendications 4 à 8, les premier et deuxième organes thermoélectriques étant en contact dans une zone de connexion électrique (280), ou étant distants l'un de l'autre et étant connectés électriquement par un pont électriquement conducteur (260a-b).

10. Dispositif choisi parmi un convertisseur d'énergie, un boitier de commande d'un moteur, un amplificateur de puissance hyperfréquence, le dispositif comportant un composant électronique selon l'une quelconque des revendications précédentes.

11. Procédé de fabrication d'un composant électronique (365) selon l'une quelconque des revendications précédentes comportant un transistor de puissance (355) et un capteur thermoélectrique (360) ayant des premier (105a-b) et deuxième (170a-b) organes thermoélectriques, le procédé comportant les étapes successives suivantes de :
a) dépôt d'un premier matériau sur un substrat (5) pour former une couche de base (20) du transistor de puissance et une couche de base (25) du capteur thermoélectrique, le premier matériau étant choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges,
b) dopage de type n ou de type p d'au moins une portion (45) de la couche de base (25) du capteur thermoélectrique, ou
dépôt d'un deuxième matériau au contact de la couche de base (25) du capteur thermoélectrique pour former une couche additionnelle (385) du capteur thermoélectrique, suivi du dopage de type n ou de type p d'au moins une portion, de préférence de l'intégralité, de la couche additionnelle du capteur thermoélectrique,
le deuxième matériau étant différent du premier matériau et étant choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges,
c) formation d'au moins une rainure (90a-b) traversant de part en part la portion dopée (45) de la couche de base du capteur thermoélectrique ou traversant de part en part la portion dopée de la couche additionnelle (385) du capteur thermoélectrique,
la portion dopée de la couche de base du capteur thermoélectrique ou de la couche additionnelle du capteur thermoélectrique contigüe à la rainure et qui s'étend le long de la rainure définissant le premier organe thermoélectrique (105a-b),
d) formation d'au moins un revêtement d'isolation électrique (130a-b) recouvrant en tout ou partie la ou les faces (135a-b,140a-b,145a-b) de la rainure,
e) formation d'au moins une couche d'insertion au moins en partie au contact avec le revêtement d'isolation électrique, et optionnellement dopage de type p ou de type n respectivement de la couche d'insertion, pour former le deuxième organe thermoélectrique (170a-b).

12. Procédé selon la revendication 11, l'étape b) comportant le dopage de type n ou de type p d'au moins une portion de la couche de base (25) du capteur thermoélectrique et l'étape c) comportant la formation d'au moins une rainure (90a-b) traversant de part en part la portion dopée (45) de la couche de base du capteur thermoélectrique,
la portion dopée de la couche de base du capteur thermoélectrique qui s'étend le long de la rainure définissant le premier organe thermoélectrique (105a-b).

13. Procédé selon la revendication 11, l'étape b) comportant le dépôt d'un deuxième matériau au contact de la couche de base du capteur thermoélectrique pour former la couche additionnelle (385) du capteur thermoélectrique, suivi du dopage de type n ou de type p d'au moins une portion, de préférence de l'intégralité, de la couche additionnelle du capteur thermoélectrique,
le deuxième matériau étant différent du premier matériau et étant choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges, et l'étape c) comportant la formation d'au moins une rainure (90a-b) traversant de part en part la portion dopée de la couche additionnelle (385) du capteur thermoélectrique,
la portion dopée de la couche additionnelle du capteur thermoélectrique contigüe à la rainure et qui s'étend le long de la rainure définissant le premier organe thermoélectrique (105a-b), comportant en particulier à l'étape b), conjointement à la formation de la couche additionnelle du capteur thermoélectrique, le dépôt du deuxième matériau sur la couche de base du transistor pour former une couche additionnelle (356) du transistor.

14. Procédé selon l'une quelconque des revendications 11 à 13, comportant de dépôt d'un troisième matériau dans la rainure, le troisième matériau étant un métal thermoélectrique, de préférence l'aluminium, ou étant un matériau semi-conducteur choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges, de préférence le nitrure de gallium ou le nitrure d'aluminium-gallium.

15. Procédé selon l'une quelconque des revendications 11 à 14, l'étape d) étant conduite pour que le revêtement d'isolation électrique recouvre intégralement la ou les faces (135a-b, 140a-b, 145a-b) de la rainure, le procédé comportant en outre une étape de formation d'un connecteur électrique reliant électriquement les premier et deuxième organes thermoélectriques, pour former un couple thermoélectrique.

16. Procédé selon l'une quelconque des revendications 11 à 15, comportant :
- la formation de plusieurs rainures à l'étape c), deux rainures adjacentes étant séparées par un premier organe thermoélectrique adjacent,
- la formation de plusieurs revêtements d'isolation électrique recouvrant chacun au moins partiellement la ou les faces d'une des rainures correspondante, et
- la formation et, optionnellement le dopage, de plusieurs couches d'insertion, chacune contenue dans une des rainures correspondante,
les couches d'insertion, optionnellement dopées, définissant avec des zones adjacentes de la portion dopée de la couche de base du capteur thermoélectrique ou de la portion dopée de la couche additionnelle du capteur électriques, plusieurs couples thermoélectriques, et
- optionnellement la formation d'au moins un organe d'interconnexion (340a-b) pour relier électriquement, de préférence en série, au moins deux des couples thermoélectriques.

## Patentansprüche

1. Elektronikbauteil (365), umfassend einen Träger (10), einen thermoelektrischen Sensor (350) und einen Leistungstransistor (355), die auf dem Träger angeordnet sind, wobei der Leistungstransistor eine Basisschicht (20) umfasst, die ein Transistormaterial enthält, das unter Galliumnitrid, Aluminium-Gallium-Nitrid, Galliumarsenid, Gallium-Indium, Gallium-Indium-Nitrid, Aluminiumnitrid, Aluminium-Indium-Nitrid und ihren Mischungen gewählt ist,
wobei das Elektronikbauteil dazu ausgestaltet ist, dass der thermoelektrische Sensor unter der Wirkung einer Erwärmung des Leistungstransistors einen elektrischen Strom erzeugt.

2. Elektronikbauteil nach Anspruch 1, wobei der thermoelektrische Sensor mehrschichtig ist und eine Basisschicht (25) umfasst, die zu mehr als 99,9 % ihrer Masse ein Sensormaterial umfasst, das unter Galliumnitrid, Aluminium-Gallium-Nitrid, Galliumarsenid, Gallium-Indium, Gallium-Indium-Nitrid, Aluminiumnitrid, Aluminium-Indium-Nitrid und ihren Mischungen gewählt ist, wobei das Sensormaterial und das Transistormaterial bevorzugt identisch sind, wobei sie bevorzugt Galliumnitrid sind.

3. Elektronikbauteil nach Anspruch 2, wobei die Basisschicht des thermoelektrischen Sensors mittels eines Dotierungselements n- oder p-dotiert ist, wobei die Basisschicht des thermoelektrischen Sensors insbesondere aus einem leeren Abschnitt (55) ohne Dotierungselement besteht und aus einem dotierten Abschnitt (45), der das Dotierungselement enthält, wobei sich der dotierte Abschnitt bevorzugt direkt unter der Oberseite (50) der Basisschicht (25) des thermoelektrischen Sensors erstreckt.

4. Elektronikbauteil nach einem der vorhergehenden Ansprüche, wobei der thermoelektrische Sensor mindestens ein Thermopaar (300a-b) umfasst, das erste (105a-b) und zweite (170a-b) thermoelektrische Organe beinhaltet, wobei das erste thermoelektrische Organ aus einem n-dotierten oder p-dotierten halbleitenden Material ist und wobei das zweite thermoelektrische Organ aus einem p-dotierten beziehungsweise n-dotierten halbleitenden thermoelektrischen Material oder aus einem thermoelektrischen Metall ist.

5. Elektronikbauteil nach dem vorhergehenden Anspruch, wobei das erste thermoelektrische Organ (170a-b) durch die gesamte oder einen Teil einer Schicht des thermoelektrischen Sensors gebildet wird, die n-dotiert oder p-dotiert ist, bevorzugt mindestens zum Teil durch den dotierten Abschnitt (45a-c) der Basisschicht des thermoelektrischen Sensors.

6. Elektronikbauteil nach einem der Ansprüche 2 bis 4, wobei der thermoelektrische Sensor eine zusätzliche Schicht (385) umfasst, die aus einem halbleitenden Material gebildet ist, bei dem mindestens ein Abschnitt n- oder p-dotiert ist, wobei die zusätzliche Schicht (385) der Oberseite (50) der Basisschicht (25) des thermoelektrischen Sensors überlagert ist und bevorzugt in Kontakt mit ihr ist,
wobei das erste thermoelektrische Organ (105a-b) bevorzugt vollständig oder teilweise durch den dotierten Abschnitt der zusätzlichen Schicht (385) gebildet wird.

7. Elektronikbauteil nach einem der Ansprüche 4 bis 6, wobei das zweite thermoelektrische Organ mindestens teilweise in einer Rille (90a-b) aufgenommen ist, die in der Basisschicht des thermoelektrischen Sensors und/oder, gegebenenfalls, in der zusätzlichen Schicht des thermoelektrischen Sensors ausgebildet ist.

8. Elektronikbauteil nach einem der Ansprüche 4 bis 7, wobei der thermoelektrische Sensor einen Überzug zur elektrischen Isolation (130a-b) aus einem elektrisch isolierenden Material umfasst, der zwischen dem ersten thermoelektrischen Organ und dem zweiten thermoelektrischen Organ angeordnet ist.

9. Elektronikbauteil nach einem der Ansprüche 4 bis 8, wobei die ersten und zweiten thermoelektrischen Organe in einem elektrischen Anschlussbereich (280) in Kontakt sind oder voneinander entfernt sind und über eine elektrisch leitende Brücke (260a-b) elektrisch angeschlossen sind.

10. Vorrichtung, die unter einem Energiewandler, einem Steuergerät eines Motors, einem Höchstfrequenz-Leistungsverstärker gewählt ist, wobei die Vorrichtung ein Elektronikbauteil nach einem der vorhergehenden Ansprüche umfasst.

11. Verfahren zur Herstellung eines Elektronikbauteils (365) nach einem der vorhergehenden Ansprüche, das einen Leistungstransistor (355) und einen thermoelektrischen Sensor (360) umfasst, der erste (105a-b) und zweite (170a-b) thermoelektrische Organe besitzt, wobei das Verfahren die folgenden aufeinander folgenden Schritte umfasst:
a) Abscheiden eines ersten Materials auf einem Substrat (5), um eine Basisschicht (20) des Leistungstransistors und eine Basisschicht (25) des thermoelektrischen Sensors zu bilden, wobei das erste Material unter Galliumnitrid, Aluminium-Gallium-Nitrid, Galliumarsenid, Gallium-Indium, Gallium-Indium-Nitrid, Aluminiumnitrid, Aluminium-Indium-Nitrid und ihren Mischungen gewählt ist,
b) n- oder p-Dotieren mindestens eines Abschnitts (45) der Basisschicht (25) des thermoelektrischen Sensors oder Abscheiden eines zweiten Materials in Kontakt mit der Basisschicht (25) des thermoelektrischen Sensors, um eine zusätzliche Schicht (385) des thermoelektrischen Sensors zu bilden, gefolgt von dem n- oder p-Dotieren mindestens eines Abschnitts, bevorzugt der Gesamtheit, der zusätzlichen Schicht des thermoelektrischen Sensors, wobei das zweite Material von dem ersten Material verschieden ist und unter Galliumnitrid, Aluminium-Gallium-Nitrid, Galliumarsenid, Gallium-Indium, Gallium-Indium-Nitrid, Aluminiumnitrid, Aluminium-Indium-Nitrid und ihren Mischungen gewählt ist,
c) Bilden mindestens einer Rille (90a-b), die den dotierten Abschnitt (45) der Basisschicht des thermoelektrischen Sensors von einer Seite zur anderen durchquert oder den dotierten Abschnitt der zusätzlichen Schicht (385) des thermoelektrischen Sensors von einer Seite zur anderen durchquert,
wobei der dotierte Abschnitt der Basisschicht des thermoelektrischen Sensors oder der zusätzlichen Schicht des thermoelektrischen Sensors, der an die Rille angrenzt und der sich entlang der Rille erstreckt, das erste thermoelektrische Organ (105a-b) definiert,
d) Bilden mindestens eines Überzugs zur elektrischen Isolation (130a-b), der die Seite oder Seiten (135a-b, 140a-b, 145a-b) der Rille vollständig oder teilweise überzieht,
e) Bilden mindestens einer Insertionsschicht, die mindestens teilweise in Kontakt mit dem Überzug zur elektrischen Isolation ist, und optional p-beziehungsweise n-Dotieren der Insertionsschicht, um das zweite thermoelektrische Organ (170a-b) zu bilden.

12. Verfahren nach Anspruch 11, wobei der Schritt b) das n- oder p-Dotieren mindestens eines Abschnitts der Basisschicht (25) des thermoelektrischen Sensors umfasst und wobei der Schritt c) das Bilden mindestens einer Rille (90a-b) umfasst, die den dotierten Abschnitt (45) der Basisschicht des thermoelektrischen Sensors von einer Seite zur anderen durchquert,
wobei der dotierte Abschnitt der Basisschicht des thermoelektrischen Sensors, der sich entlang der Rille erstreckt, das erste thermoelektrische Organ (105a-b) definiert.

13. Verfahren nach Anspruch 11, wobei der Schritt b) das Abscheiden eines zweiten Materials in Kontakt mit der Basisschicht des thermoelektrischen Sensors umfasst, um die zusätzliche Schicht (385) des thermoelektrischen Sensors zu bilden, gefolgt von dem n- oder p-Dotieren mindestens eines Abschnitts, bevorzugt der Gesamtheit, der zusätzlichen Schicht des thermoelektrischen Sensors, wobei das zweite Material von dem ersten Material verschieden ist und unter Galliumnitrid, Aluminium-Gallium-Nitrid, Galliumarsenid, Gallium-Indium, Gallium-Indium-Nitrid, Aluminiumnitrid, Aluminium-Indium-Nitrid und ihren Mischungen gewählt ist und wobei der Schritt c) das Bilden mindestens einer Rille (90a-b) umfasst, die den dotierten Abschnitt der zusätzlichen Schicht (385) des thermoelektrischen Sensors von einer Seite zur anderen durchquert,
wobei der dotierte Abschnitt der zusätzlichen Schicht des thermoelektrischen Sensors, der an die Rille angrenzt und der sich entlang der Rille erstreckt, das erste thermoelektrische Organ (105a-b) definiert, umfassend insbesondere im Schritt b), gemeinsam mit dem Bilden der zusätzlichen Schicht des thermoelektrischen Sensors, das Abscheiden des zweiten Materials auf der Basisschicht des Transistors, um eine zusätzliche Schicht (356) des Transistors zu bilden.

14. Verfahren nach einem der Ansprüche 11 bis 13, umfassend das Abscheiden eines dritten Materials in der Rille, wobei das dritte Material ein thermoelektrisches Metall ist, bevorzugt Aluminium, oder ein halbleitendes Material ist, das unter Galliumnitrid, Aluminium-Gallium-Nitrid, Galliumarsenid, Gallium-Indium, Gallium-Indium-Nitrid, Aluminiumnitrid, Aluminium-Indium-Nitrid und ihren Mischungen gewählt ist, bevorzugt Galliumnitrid oder Aluminium-Gallium-Nitrid.

15. Verfahren nach einem der Ansprüche 11 bis 14, wobei der Schritt d) durchgeführt wird, damit der Überzug zur elektrischen Isolation die Seite oder Seiten (135a-b, 140a-b, 145a-b) der Rille vollständig überzieht, wobei das Verfahren ferner einen Schritt des Bildens eines elektrischen Verbinders umfasst, der die ersten und zweiten thermoelektrischen Organe elektrisch verbindet, um ein Thermopaar zu bilden.

16. Verfahren nach einem der Ansprüche 11 bis 15, umfassend:
- das Bilden von mehreren Rillen im Schritt c), wobei zwei benachbarte Rillen durch ein benachbartes erstes thermoelektrisches Organ getrennt sind,
- das Bilden von mehreren Überzügen zur elektrischen Isolation, von denen jeder mindestens teilweise die Seite oder Seiten einer entsprechenden Rille der Rillen überzieht, und
- das Bilden und optional das Dotieren von mehreren Insertionsschichten, von denen jede in einer entsprechenden Rille der Rillen enthalten ist,
wobei die, optional dotierten, Insertionsschichten mit benachbarten Bereichen des dotierten Abschnitts der Basisschicht des thermoelektrischen Sensors oder des dotierten Abschnitts der zusätzlichen Schicht des elektrischen Sensors mehrere Thermopaare definieren, und
- optional das Bilden mindestens eines Zusammenschaltungsorgans (340a-b), um mindestens zwei der Thermopaare, bevorzugt in Reihe, elektrisch zu verbinden.

## Claims

1. Electronic component (365) comprising a carrier (10), a thermoelectric sensor (350) and a power transistor (355) which are arranged on the carrier, the power transistor comprising a base layer (20) containing a transistor material selected from gallium nitride, gallium-aluminium nitride, gallium arsenide, indium-gallium, indium-gallium nitride, aluminium nitride, indium-aluminium nitride and mixtures thereof,
the electronic component being configured so that the thermoelectric sensor generates an electrical current under the effect of a heating of the power transistor.

2. Electronic component according to Claim 1, the thermoelectric sensor being multilayer and comprising a base layer (25) comprising, accounting for more than 99.9% of its mass, a sensor material selected from gallium nitride, gallium-aluminium nitride, gallium arsenide, indium-gallium, indium-gallium nitride, aluminium nitride, indium-aluminium nitride and mixtures thereof, the sensor material and the transistor material preferably being identical and preferably being gallium nitride.

3. Electronic component according to Claim 2, the base layer of the thermoelectric sensor being n-doped or p-doped with a dopant element, the base layer of the thermoelectric sensor in particular consisting of a virgin portion (55) free of the dopant element, and a doped portion (45) containing the dopant element, the doped portion preferably extending directly beneath the upper face (50) of the base layer (25) of the thermoelectric sensor.

4. Electronic component according to any one of the preceding claims, the thermoelectric sensor comprising at least one thermoelectric couple (300a-b) including a first (105a-b) and second (170a-b) thermoelectric members, the first thermoelectric member being made from an n-doped or p-doped semiconductor material and the second thermoelectric member being made from a p-doped or n-doped thermoelectric semiconductor material respectively, or from a thermoelectric metal.

5. Electronic component according to the preceding claim, the first thermoelectric member (170a-b) being formed by all or part of a layer of the thermoelectric sensor which layer is n-doped or p-doped, preferably at least in part by the doped portion (45a-c) of the base layer of the thermoelectric sensor.

6. Electronic component according to any one of Claims 2 to 4, the thermoelectric sensor comprising an additional layer (385) formed from a semiconductor material of which at least a portion is n-doped or p-doped, the additional layer (385) being superposed, and preferably in contact, with the upper face (50) of the base layer (25) of the thermoelectric sensor,
the first thermoelectric member (105a-b) preferably being formed in full or in part by the doped portion of said additional layer (385).

7. Electronic component according to any one of Claims 4 to 6, the second thermoelectric member being housed at least in part in a slot (90a-b) formed in the base layer of the thermoelectric sensor and/or, as applicable, in the additional layer of the thermoelectric sensor.

8. Electronic component according to any one of Claims 4 to 7, the thermoelectric sensor comprising an electrical insulation coating (130a-b) made from an electrically insulating material, positioned between the first thermoelectric member and the second thermoelectric member.

9. Electronic component according to any one of Claims 4 to 8, the first and second thermoelectric members being in contact in an electrical-connection zone (280), or being distant from one another and being electrically connected by an electrically conducting bridge (260a-b).

10. Device selected from an energy converter, a motor control unit, a microwave power amplifier, the device comprising an electronic component according to any one of the preceding claims.

11. Method for manufacturing an electronic component (365) according to any one of the preceding claims, comprising a power transistor (355) and a thermoelectric sensor (360) having a first (105a-b) and a second (170a-b) thermoelectric members, the method comprising the following successive steps of:
a) depositing a first material on a substrate (5) to form a base layer (20) of the power transistor and a base layer (25) of the thermoelectric sensor, the first material being selected from gallium nitride, gallium-aluminium nitride, gallium arsenide, indium-gallium, indium-gallium nitride, aluminium nitride, indium-aluminium nitride and mixtures thereof,
b) n-doping or p-doping at least a portion (45) of the base layer (25) of the thermoelectric sensor, or depositing a second material in contact with the base layer (25) of the thermoelectric sensor so as to form an additional layer (385) of the thermoelectric sensor, followed by n-doping or p-doping of at least a portion, preferably the entirety, of the additional layer of the thermoelectric sensor,
the second material being different from the first material and being chosen from gallium nitride, gallium-aluminium nitride, gallium arsenide, indium-gallium, indium-gallium nitride, aluminium nitride, indium-aluminium nitride and mixtures thereof,
c) forming at least one slot (90a-b) that passes right through the doped portion (45) of the base layer of the thermoelectric sensor or that passes right through the doped portion of the additional layer (385) of the thermoelectric sensor,
the doped portion of the base layer of the thermoelectric sensor or of the additional layer of the thermoelectric sensor which is contiguous with the slot and which extends along the slot defining the first thermoelectric member (105a-b),
d) forming at least one electrical insulation coating (130a-b) that completely or partially covers the face or faces (135a-b, 140a-b, 145a-b) of the slot,
e) forming at least one insert layer at least partially in contact with the electrical insulation coating and optionally respectively p-doping or n-doping the insert layer, so as to form the second thermoelectric member (170a-b).

12. Method according to Claim 11, step b) involving n-doping or p-doping at least a portion of the base layer (25) of the thermoelectric sensor, and step c) involving forming at least one slot (90a-b) that passes right through the doped portion (45) of the base layer of the thermoelectric sensor,
the doped portion of the base layer of the thermoelectric sensor which extends along the slot defining the first thermoelectric member (105a-b).

13. Method according to Claim 11, step b) involving depositing a second material in contact with the base layer of the thermoelectric sensor so as to form the additional layer (385) of the thermoelectric sensor, followed by n-doping or p-doping of at least a portion, preferably the entirety, of the additional layer of the thermoelectric sensor,
the second material being different from the first material and being chosen from gallium nitride, gallium-aluminium nitride, gallium arsenide, indium-gallium, indium-gallium nitride, aluminium nitride, indium-aluminium nitride and mixtures thereof,
and step c) involving the formation of at least one slot (90a-b) that passes right through the doped portion of the additional layer (385) of the thermoelectric sensor, the doped portion of the additional layer of the thermoelectric sensor which is contiguous with the slot and which extends along the slot defining the first thermoelectric member (105a-b), involving, particularly in step b), together with the formation of the additional layer of the thermoelectric sensor, the depositing of the second material on the base layer of the transistor in order to form an additional layer (356) of the transistor.

14. Method according to any one of Claims 11 to 13, involving depositing a third material in the slot, the third material being a thermoelectric metal, preferably aluminium, or being a semiconductor material chosen from gallium nitride, gallium-aluminium nitride, gallium arsenide, indium-gallium, indium-gallium nitride, aluminium nitride, indium-aluminium nitride and mixtures thereof, preferably gallium nitride or gallium-aluminium nitride.

15. Method according to any one of Claims 11 to 14, step d) being conducted so that the electrical insulation coating entirely covers the face or faces (135a-b, 140a-b, 145a-b) of the slot, the method further comprising a step of forming an electrical connector electrically connecting the first and second thermoelectric members to form a thermoelectric couple.

16. Method according to any one of Claims 11 to 15, involving:
- forming several slots in step c), two adjacent slots being separated by an adjacent first thermoelectric member,
- forming several electrical insulation coatings each at least partially covering the face or faces of a corresponding one of the slots, and
- forming, and optionally doping, several insert layers, each one contained in a corresponding one of the slots, the insert layers, which are optionally doped, defining with adjacent zones of the doped portion of the base layer of the thermoelectric sensor or of the doped portion of the additional layer of the electric sensor, a plurality of thermoelectric couples, and
- optionally forming at least one interconnect member (340a-b) so as to electrically connect, preferably in series, at least two of the thermoelectric couples.
